(19) Europäisches Patentamt
European Patent Office
Office européen des brevets

(11) EP 3 537 855 B1

(12) # FASCICULE DE BREVET EUROPEEN

(45) Date de publication et mention de la délivrance du brevet:
**07.06.2023 Bulletin 2023/23**

(21) Numéro de dépôt: **18305249.7**

(22) Date de dépôt: **08.03.2018**

(51) Classification Internationale des Brevets (IPC):
***H05K 3/04*** *(2006.01)* ***H05K 1/02*** *(2006.01)*
***G06K 19/067*** *(2006.01)*

(52) Classification Coopérative des Brevets (CPC):
**G06K 19/0672; G06K 19/067; H05K 1/0242; H05K 3/046**

(54) **PROCÉDÉ DE FABRICATION DE DISPOSITIFS D'IDENTIFICATION PAR FRÉQUENCE RADIO (" RFID ") SANS PUCE PERSONNALISÉS**

HERSTELLUNGSVERFAHREN VON PERSONALISIERTEN IDENTIFIZIERUNGSVORRICHTUNGEN ÜBER FUNKFREQUENZ ( RFID ) OHNE CHIP

METHOD FOR MANUFACTURING PERSONALISED CHIP-FREE RADIOFREQUENCY IDENTIFICATION (RFID) DEVICES

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(43) Date de publication de la demande:
**11.09.2019 Bulletin 2019/37**

(73) Titulaires:
- **MGI Digital Technology**
  **94260 Fresnes (FR)**
- **Inkjet Engine Technology**
  **92190 Meudon (FR)**

(72) Inventeurs:
- **ABERGEL, Edmond**
  **75012 Paris (FR)**
- **GAUTIER LE BOULCH, Louis**
  **92190 Meudon (FR)**

(74) Mandataire: **De Kezel, Eric et al**
**Mathisen & Macara LLP**
**Charta House**
**30-38 Church Street**
**Staines-upon-Thames, Middlesex TW18 4EP (GB)**

(56) Documents cités:
**EP-A2- 0 045 466** **EP-A2- 0 414 362**
**EP-A2- 2 056 656** **CA-A1- 2 089 060**
**US-A- 5 250 758** **US-A1- 2007 102 103**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

EP 3 537 855 B1

## Description

La présente invention concerne un procédé de fabrication de dispositifs d'identification par fréquence radio (« RFID ») sans puce personnalisés, en particulier la fabrication d'étiquettes RFID sans puce personnalisées, aussi appelées « chip-less RFID tags ». La présente invention concerne également les dispositifs et étiquettes fabriquées par le procédé revendiqué ainsi que les systèmes pour fabriquer les dits dispositifs/étiquettes.

Par « dispositif » il faut comprendre un emballage, un document, une étiquette, notamment un document de sécurité ainsi qu'éventuellement tout objet sur lequel le marquage de l'identification par RFID sans puce peut être réalisé ou sur lequel un support du marquage peut être rapporté.

### Exposé de l'art antérieur

Les systèmes de transmission de données utilisant la technologie d'identification par fréquence radio sont couramment utilisés pour identifier tous types d'objets et d'êtres vivants (par exemple un animal ou un humain) porteurs d'un dispositif (étiquette) adapté. La technologie RFID est devenue au cours des dernières décennies de plus en plus répandue en tant que dispositif de stockage et de transmission d'informations.

Cette technologie RFID utilise une radio-étiquette, également dénommée transpondeur (de l'anglais « transponder », par contraction des mots « transmitter » et « responder »), qui est placée sur un objet, et un lecteur, également dénommé interrogateur, pour lire et identifier la radio-étiquette. Les technologies RFID sont généralement classées en catégories utilisant des radio-étiquettes «actives» ou «passives». Les radio-étiquettes actives disposent d'une source d'énergie locale (telle qu'une batterie) grâce à laquelle elles envoient un signal au lecteur ; elles sont ainsi généralement caractérisées par une portée de signal émis relativement longue. En revanche, les radio-étiquettes passives ne disposent pas de source d'alimentation interne car leur énergie d'émission de signal provient du lecteur lui-même, et en particulier de la réception du signal émis par le lecteur ; ainsi, les radio-étiquettes passives ont une portée de signal beaucoup plus faible, en générale inférieure à 8 mètres.

D'un point de vue pratique, la technologie RFID utilise des fréquences radio qui ont des caractéristiques de pénétration du matériau beaucoup plus élevées que les signaux optiques. Ainsi, en comparaison avec les étiquettes codes à barres, la technologie RFID permettra une utilisation dans des conditions environnementales bien plus hostiles ; par exemple, les étiquettes RFID peuvent être lues à travers toute sorte de matière telle que le papier, le carton, le bois, la peinture, l'eau, la saleté, la poussière, le corps animal ou humain, le béton ou encore à travers l'article étiqueté lui-même ou son emballage. Ceci a ouvert aux étiquettes RFID une large gamme d'applications parmi lesquelles nous citerons à titre illustratif, l'identification des biens et des personnes, en particulier des emballages, des voitures (parking, péages, ...), la gestion des inventaires, les cartes d'accès électroniques, sans oublier tous les documents de sécurité tels que par exemple un moyen de paiement, tel qu'un billet de banque, un chèque ou un ticket restaurant, un document d'identité, tel qu'une carte d'identité, un visa, un passeport ou un permis de conduire, un ticket de loterie, un titre de transport ou encore un ticket d'entrée à des manifestations culturelles ou sportives.

Il existe principalement deux types d'étiquettes RFID, les étiquettes comprenant un circuit électronique intégré, dites étiquettes à puce (électronique), et les étiquettes ne comprenant pas de circuit électronique intégré, généralement désignées dans la technique par les termes anglais « chip-less RFID tags » - étiquettes RFID sans puce.

Les étiquettes RFID à puce (actives ou passives) comprennent généralement une antenne, un circuit électronique, une mémoire pour stocker un code d'identification. Le circuit électronique permet notamment de recevoir le signal émis par la borne de lecture et d'émettre en réponse, dans une bande de fréquences déterminée, un signal modulé contenant le code d'identification stocké dans la mémoire. Pour les étiquettes RFID à puce passives, une partie de l'énergie portée par les ondes radio émises par la borne de lecture sert à alimenter électriquement la puce.

Du fait de la présence de circuits électroniques dans les étiquettes RFID à puce, ces étiquettes ont un coût de revient non négligeable. C'est notamment pour réduire ce coût de revient qu'on a proposé de réaliser des étiquettes sans puce. Ce type d'étiquette RFID sans puce ne nécessite donc ni circuit intégré, ni composants électroniques discrets, tels que par exemple un transistor et/ou une bobine et/ou une capacité et/ou une antenne; c'est leur caractéristique géométrique conductrice qui engendre un comportement spécifique, notamment de type résonateur. Cette caractéristique de résonance à fréquence donnée permet d'imprimer des étiquettes RFID sans puce directement sur un substrat à des coûts inférieurs à ceux des étiquettes RFID traditionnelles.

Les étiquettes RFID sans puce sont typiquement préparées par des techniques de gravure ou d'estampage dans lesquelles une feuille est découpée pour créer la structure finale. Par exemple, c'est en gravant dans un film conducteur un ensemble spécifique de structures déterminant des fréquences de résonance, qu'on parvient grâce à l'ensemble des fréquences de résonance de définir un code d'identification correspondant. Ce procédé augmente le coût de telles étiquettes en exigeant que chaque résonateur soit fabriqué individuellement, par exemple par gravure au laser, ce qui est un processus non seulement coûteux mais également délicat à développer industriellement.

L'utilisation d'encre métallique conductrice a également été décrite comme technologie d'impression directe

d'étiquettes RFID sans puce sur substrat, par exemple l'impression à jet d'encre. Malheureusement, l'impression à jet d'encre conductrice ne s'est pas encore révélée satisfaisante pour l'impression de dispositifs RFID sans puce personnalisés. D'une part, les particules d'encre conductrices de petits diamètres, uniformes et en matériau à haute conductivité comme l'or et l'argent sont trop coûteuses. D'autre part, si on se contente de particules bon marché, elles sont généralement caractérisées par une faible conductivité et de tailles variables incompatibles avec l'inter connectivité globale nécessaire aux structures imprimées pour réaliser des dispositifs RFID sans puce personnalisés. De plus, certains supports sont incompatibles avec une impression directe d'encre conductrice ce qui en limite fortement les applications. En conséquence, les têtes d'impression à jet d'encre ne sont pas appropriées pour imprimer l'encre à l'échelle nécessaire pour coder des structures résonantes individuelles sur tout type de support.

Il a également été proposé dans la demande de brevet US2009128290 une technologie d'impression hybride combinant des procédés d'impression analogiques avec des procédés d'impression numérique d'encre conductrice ; en particulier, US2009128290 revendique un procédé d'impression d'étiquettes RFID sans puce comprenant: l'impression d'un précurseur de modèle d'antenne RFID en utilisant un premier procédé d'impression (analogique consistant en héliogravure, flexographie et sérigraphie), dans lequel le précurseur de modèle d'antenne RFID comprend une pluralité de segments de câble déconnectés; et l'impression d'une encre conductrice (comprenant un matériau choisi dans le groupe consistant en graphite, cuivre, or, nickel, argent, aluminium, platine et leurs mélanges) en utilisant un second procédé d'impression à jet d'encre pour interconnecter au moins deux desdits plusieurs segments de fils déconnectés. Ce procédé permet de fabriquer des étiquettes sans puce unitaires (à savoir chacune avec un motif conducteur unique) tout en s'appuyant fortement sur un procédé industriel éprouvé pour l'impression du précurseur, c'est-à-dire la surface principale du motif conducteur constituant l'étiquette; le motif conducteur final est donc réalisé en deux étapes au moyen de deux techniques différentes. On remarque que dans ce procédé, à chaque étape un motif conducteur différent est réalisé.

Bien que la technologie RFID sans puce soit promise à un bel avenir, il n'en demeure pas moins que l'on recherche toujours une technique alternative moins coûteuse et plus efficace que les méthodes conventionnelles connues à ce jour pour fabriquer des étiquettes RFID personnalisées de ce type.

L'état de l'art le plus proche est décrit dans le document EP-A2-2 056 656. L'état de l'art comprend aussi le document CA-A1-2 089 060.

## Invention

Ainsi, la présente invention apporte une solution prometteuse à cette problématique en proposant un procédé de fabrication de dispositifs d'identification par fréquence radio (« RFID ») sans puce personnalisés, en particulier la fabrication d'étiquettes RFID sans puce personnalisées, aussi appelées « chip-less RFID tags ».

L'invention est définie dans les revendications indépendantes 1, 12 et 14. Des réalisations particulières sont définies dans les revendication dépendantes 2-11 et 13. Comme déjà expliqué dans la partie introductive, ce type de dispositif d'identification par fréquence radio sans puce ne nécessite donc ni circuit intégré, ni composants électroniques discrets, tels que par exemple un transistor et/ou une bobine et/ou une capacité et/ou une antenne. De plus, il est également évident que ce type de dispositif sera préférentiellement caractérisé par un comportement passif car il ne devra pas intégrer de source d'énergie locale (telle qu'une batterie).

Pour rappel, par « dispositif » il faut comprendre un emballage, un document, une étiquette, notamment un document de sécurité ainsi qu'éventuellement tout objet et/ou être vivant sur lequel le marquage de l'identification par RFID sans puce peut être réalisé ou sur lequel un support du marquage peut être rapporté.

Une caractéristique particulière du procédé de fabrication selon la présente invention et des dispositifs ainsi fabriqués consiste en ce que la partie conductrice du dispositif peut être réalisée en une seule étape lors du dépôt sélectif de « dorure » conductrice sur le motif préimprimé. Ceci représente un avantage additionnel par rapport à la majorité des techniques existantes qui requièrent une étape additionnelle, par exemple une étape de soudage des composants conducteurs ou la combinaison de deux technologies différentes.

Les techniques de dorure de substrat, par exemple de substrat imprimé, sont bien connues de l'homme du métier. Le principe de base de cette technique repose sur le fait de déposer un revêtement additionnel (i.e., dorure ou matière) sur le substrat, par un dispositif de dépôt de « dorure », par exemple en appliquant/pressant une feuille (portant ledit revêtement ou dorure) sur des zones sélectionnées du substrat de manière à faire adhérer aux zones sélectionnées la partie désirée de la feuille. Cette technique peut par exemple comporter un dépôt d'adhésif sur le substrat selon un motif prédéterminé avant le dépôt du revêtement de personnalisation (par exemple la feuille de dorure) sur l'adhésif déposé sur le substrat. Le dépôt de l'adhésif peut se faire au moyen d'une ou plusieurs techniques, comme par exemple l'impression par jet d'encre, l'impression à base de toner, la sérigraphie ou l'impression offset.

Il est évident pour l'homme du métier que les mots « dorure » et « dorer » utilisés dans la présente invention ne sont pas limités à l'utilisation de feuille d'or et que n'importe quel dispositif de « dorure » peut être employé. Dans le cadre de la présente invention, ces termes couvrent bien entendu tous les types de feuilles conductrices (parfois également appelées feuilles métalliques) parmi lesquels on peut citer à titre d'exemples illustratifs et non limitatifs, l'argent, le cuivre, l'or, l'aluminium, le zinc, le nickel, le fer, et/ou tout alliage et/ou sel conducteurs. En général, on utilise une feuille de dorure pressée contre le substrat à personnaliser, et la présente demande désigne donc par ce terme l'utilisation générale d'un dispositif de dorure. Toutefois, afin d'éviter tout problème d'interprétation, la Demanderesse a préféré utiliser le mot « film » (comprenant entre autres une pellicule de matière conductrice) dans la présente description et dans les revendications.

La Demanderesse est parvenue en combinant ces deux techniques d'impression que sont l'impression numérique et la dorure à répondre de manière avantageuse aux défis soulevés lors de la conception de dispositifs d'identification par fréquence radio sans puce, les dits dispositifs étant générateurs d'un code d'identification lisible par un lecteur émetteur-récepteur d'ondes électromagnétiques ; le principe de fonctionnement du dit lecteur repose sur l'émission d'un signal électromagnétique en direction du dispositif d'identification (par exemple l'étiquette) qui va réfléchir le dit signal en fonction de sa géométrie (et par exemple de ses caractéristiques de résonances propres) et sur la capture par le lecteur du dit signal réfléchi - ainsi, le traitement du signal reçu (notamment à travers une étape de décodage) permettra de remonter à l'information contenue dans le dispositif (par exemple, l'étiquette / le tag).

Ainsi, de manière générale, les dispositifs d'identification par fréquence radio sans puce selon la présente invention font partie d'un système RFID qui comprend également un ou plusieurs lecteurs RFID qui sont eux-mêmes connectés on non à des ordinateurs de supervision ou à une carte électronique qui réalise un traitement qui peuvent par exemple faire le lien avec des bases de données existantes. Ces lecteurs permettent donc d'identifier des objets grâce aux tags RFID qui y sont apposés, les dits tags RFID sans puce étant assimilables à une cible radar statique avec une signature électromagnétique spécifique. Ainsi, dans un mode d'exécution particulier de la présente invention, les lecteurs RFID sans puce sont donc assimilables à un radar en termes de fonctionnement, par exemple un radar aérien détectant la signature des avions à un rapport d'échelle et de puissance près. A titre illustratif, les tags RFID sans puce peuvent être vus comme des cibles radar possédant une signature temporelle ou fréquentielle particulière. Tout type de radar approprié à la réception/identification du signal retro-émis par le tag RFID pourra avantageusement être utilisé dans le cadre de l'invention ; à titre illustratif et non limitatif, nous citerons le radar impulsionnel.

Grâce au procédé revendiqué, il est possible de réaliser des dépôts de motifs conducteurs ayant une très bonne conductivité ainsi qu'une bonne résolution au niveau des dimensions des motifs réalisés et, plus particulièrement une précision des bords des motifs réalisés.

A titre illustratif, cette excellente conductivité est atteinte grâce à l'utilisation d'un matériau conducteur en métal d'une très bonne qualité en terme de pureté et d'agencement volumique des atomes, ce qui lui confère une conductivité d'une valeur très proche de celle du métal parfait correspondant (en parle en anglais de « bulk métal ») ; comme expliqué plus en détail dans la description qui suit, cette feuille de métal est le plus souvent réalisée par déposition sous vide ce qui permet d'obtenir la très bonne qualité du métal ainsi obtenu. La conductivité dudit métal est ainsi au moins 10 fois supérieure à celle que l'on pourrait obtenir en utilisant un autre type de technique de dépôts comme par exemple lors de l'impression d'encre conductrice (et ceci quel que soit le procédé d'impression de dépôt, par exemple la flexographie, la sérigraphie, le jet d'encre, ...). De manière inattendue et avantageuse, la Demanderesse est parvenue grâce à son procédé à obtenir des performances en terme de surface équivalente radar (Radar cross section en anglais) des étiquettes ainsi réalisées proches de celles connues en utilisant une approche de réalisation de type « circuit imprimé », par exemple par lamination sur un substrat diélectrique d'un métal volumique (comme le cuivre, typiquement d'une épaisseur de 17 $\mu$m), ce dernier ayant une structure atomique proche d'un matériau idéal, c'est-à-dire pur, dont les atomes seraient parfaitement agencés entre eux. Cette technique de réalisation de type « circuit imprimé » est connue pour être très performante ; toutefois pour des questions de prix et d'efficacité de fabrication, elle est incompatible avec la réalisation des dispositifs d'identification par fréquence radio sans puce selon la présente invention. La surface équivalente radar est une grandeur très importante pour caractériser la performance intrinsèque des étiquettes RFID sans puce. Elle indique pour une puissance donnée émise, le niveau de puissance qui va être rétrodiffusé par la cible (ici l'étiquette) dans l'espace, et tout particulièrement dans la direction de l'onde émise. Elle est liée à plusieurs paramètres de l'étiquette comme en premier lieu la forme des motifs conducteurs, la conductivité des motifs conducteurs, et leur épaisseur. On note que le choix de l'épaisseur du métal dans les circuits imprimés est lié à un phénomène physique connu sous le nom d'effet de peau. Ce phénomène renvoie à la notion d'épaisseur de peau ($\delta$ en mètre, qui dépend de la fréquence du signal) qu'on peut représenter par la formule

$$\delta = \sqrt{\frac{2}{\omega\mu\sigma}} = \sqrt{\frac{2\rho}{\omega\mu}} = \frac{1}{\sqrt{\sigma\mu\pi f}}$$

dans laquelle $\delta$ est l'épaisseur de peau en mètre [m],

f est la fréquence du courant en hertz [Hz],
$\omega$ est la pulsation en radian par seconde [rad/s] ($\omega$=2.$\pi$.f)
$\sigma$ est la conductivité électrique en siemens par mètre [S/m]
p est la résistivité en ohm-mètre [$\Omega$.m]($\rho$=1/$\sigma$) , et
$\mu$ est la perméabilité magnétique en henry par mètre [H/m], cette perméabilité valant 4$\pi$10-7 pour le vide

qui indique l'épaisseur minimum de métal qui va permettre au courant électrique de circuler d'une manière optimale ; ainsi, ce phénomène permet de caractériser la surface « S » dans la section transverse du conducteur où se concentre le courant. Dans la mesure où cette surface S intervient directement dans l'expression de la résistance R d'un fil conducteur homogène (R=p.l/S, avec / la longueur en mètre du fil et $\rho$ la résistivité en ohm-mètre), l'effet de peau a un intérêt tout particulier lorsque l'on s'intéresse aux pertes par effet joule et donc aux performances des matériaux conducteurs et donc de nos dispositifs d'identification par fréquence radio sans puce. En effet, l'onde qui est envoyée sur les dispositifs (étiquettes) crée un courant qui circule au niveau des motifs conducteurs. Comme ces courants sont à l'origine de l'onde rétrodiffusée, ils interviennent donc directement dans le niveau de puissance de la signature RF que le lecteur va être en mesure d'enregistrer (en première approximation et dans le cas simple d'une repartions linéaire de courant selon une direction (exemple d'un dipôle en court-circuit), plus l'amplitude du courant est grande au niveau de la piste conducteur, plus la surface équivalente radar est grande, ceci pour une puissance émisse donnée). Pour maximiser le signal rétrodiffusé, il est important de s'assurer de la bonne conductivité des matériaux ainsi que de la bonne circulation du courant dans les matériaux conducteurs présents sur les dispositifs (étiquettes). Ainsi, pour des structures planaires de section rectangulaire, c'est-à-dire des motifs correspondants à ceux réalisés dans le cadre de la présente invention, lorsque l'épaisseur de la couche conductrice est inférieure à deux fois l'épaisseur de peau à la fréquence considérée, la surface S dans laquelle le courant peut circuler est en première approximation inférieure à celle qu'il pourrait avoir dans un cas plus avantageux correspondant à une épaisseur plus grande. Ceci devrait naturellement conduire à sélectionner des épaisseurs de motifs conducteurs, et donc de pellicule conductrice du film de dorure plus épaisses que le double de l'épaisseur de peau puisqu'un des objectifs recherchés est la conductivité et la bonne circulation de courant au sein des dispositifs. En effet, toute diminution de la surface transverse du motif conducteur par rapport au cas optimal donnée par la relation sur l'épaisseur de peau va augmenter la résistance du dit motif conducteur et donc entraîner des pertes par effets joule conformément à la relation R=p.l/S.

Toutefois, la Demanderesse a constaté de manière inattendue que les dispositifs d'identification par fréquence radio sans puce fabriqués selon le procédé revendiqué permettaient de répondre aux exigences de conductivité et de circulation de courant nécessaires à leur utilisation/destination avec des épaisseurs de pellicule conductrice inférieures à ce que la théorie aurait préconisé.

Ainsi, selon un mode d'exécution particulier de la présente invention, les dispositifs d'identification par fréquence radio sans puce sont caractérisés en ce qu'ils comprennent des motifs imprimés dont l'épaisseur de pellicule conductrice (provenant du film de dorure) est inférieure à 2,5 fois son épaisseur de peau (calculée conformément à la formule ci-dessus) à une fréquence donnée, par exemple inférieure à 2 fois son épaisseur de peau, voire inférieure à 1,75 fois son épaisseur de peau.

Sans vouloir être limité par cette explication, la Demanderesse pense que le procédé selon la présente invention permet d'obtenir un fonctionnement optimal des dispositifs d'identification par fréquence radio sans puce qui démontrent des propriétés supérieures de conductivité électrique et de circulation de courant au sein des motifs conducteurs et une faculté inattendue d'émission-réception d'ondes électromagnétiques grâce à une combinaison de facteurs dont nous citerons à titre illustratif :

- la constitution/qualité des pellicules conductrices utilisées ;
- la résolution supérieure d'impression des motifs imprimés par voie numérique qui permet d'obtenir après dorure une qualité des motifs imprimés/dorés permettant de maintenir leurs propriétés conductrices ;
- une précision supérieure d'impression des motifs imprimés par voie numérique qui permet d'obtenir après dorure une qualité des motifs imprimés/dorés et, plus particulièrement une régularité des bords des motifs imprimés/dorés, permettant de maintenir leurs propriétés conductrices.

Ainsi, la présente invention permet de fabriquer à grande échelle des dispositifs d'identification par fréquence radio sans puce en minimisant la quantité de métal conducteur utilisée grâce aux faibles épaisseurs de pellicule conductrice permettant leur réalisation. Toutefois, et ceci constitue un mode d'exécution particulier de la présente invention, les dispositifs d'identification par fréquence radio sans puce sont également avantageusement caractérisés en ce qu'ils comprennent des motifs imprimés dont l'épaisseur de pellicule conductrice (provenant du film de dorure) est supérieure à 100 nm, par exemple de plus de 150 nm, 200 nm, 250 nm, 300 nm, 400 nm, voire même de plus de 500 nm. Bien que ces épaisseurs soient supérieures aux épaisseurs habituelles (par exemple 80 nm) utilisées dans les techniques conventionnelles de dorure (par exemple les techniques d'ennoblissement de substrats), l'homme de l'art dispose de

techniques connues lui permettant de fabriquer les films comprenant cette pellicule de dorure, comme détaillé ci-après dans la description.

Selon un mode d'exécution particulier de la présente invention, les dispositifs d'identification par fréquence radio sans puce sont également avantageusement caractérisés en ce qu'ils comprennent des motifs imprimés dont l'épaisseur de pellicule conductrice (provenant du film de dorure) est inférieure à 2 microns, par exemple de moins de 1,5 microns, voire même de moins de 1 micron ou de moins de 0,75 microns.

Bien qu'il n'y ait théoriquement pas de véritable limitation en matière de choix de bande de fréquence préconisée pour l'utilisation des dispositifs d'identification par fréquence radio sans puce selon la présente invention, on utilisera de préférence une limite basse de la dite bande en fonction des valeurs d'épaisseur de peau. Ainsi, en tenant compte des valeurs d'épaisseurs des pellicules conductrices des motifs imprimés et de leur conductivité selon la présente invention, on estime que 400MHz constitue une fréquence minimale. En ce qui concerne la limite haute, on pense qu'elle est liée à la résolution des dépôts conducteurs que l'on va obtenir (qui dépend essentiellement de l'épaisseur de la pellicule conductrice du film de dorure ; ainsi, on estime que 100GHz constitue une fréquence maximale. En effet, au-delà de cette fréquence, les motifs à réaliser seront probablement trop petits par rapport à la technologie préconisée. Dans un mode d'exécution particulier selon la présente invention, une bande de fréquence supérieure à 3GHz et/ou inférieure à 10 GHz pourra avantageusement être sélectionnée.

Une spécificité avantageuse du procédé et du dispositif revendiqués réside dans la possibilité de contrôler l'épaisseur et le type de matériaux (en particulier de matériaux diélectriques) utilisés comme produit d'impression numérique entre le film de dorure contenant la pellicule conductrice et le substrat, par exemple un vernis, une encre et/ou un toner. A titre illustratif, si on considère l'utilisation de papier comme substrat pour réaliser une étiquette RFID sans puce, le support du film conducteur sera au final constitué de l'objet sur lequel l'étiquette sera placée, du papier, du produit d'impression (toner/vernis/encre) ainsi que de la pellicule d'application du film de dorure comme détaillé ci-après dans la description. Hors, l'épaisseur du produit d'impression joue un rôle important dans la signature RF de l'étiquette dans la mesure où la présence de la couche de diélectrique permet d'espacer la feuille conductrice du substrat (le papier dans notre exemple) et de l'objet ; et comme le substrat et l'objet présentent généralement davantage de pertes conductrices aux fréquences d'utilisation de l'étiquette que le produit d'impression, l'épaisseur du produit d'impression permet, en éloignant la pellicule conductrice du reste du support, d'éloigner les lignes de champ créées par l'onde incidente des matériaux à pertes tels que le substrat et l'objet. De cette manière, on diminue les pertes du signal rétrodiffusé, favorisant ainsi la résonance des motifs conducteurs et donc la puissance, ainsi que la forme générale en fréquence de l'onde rétrodiffusée, autrement dit la surface équivalente radar de l'étiquette. Le fait de favoriser le caractère résonnant des motifs va impacter favorablement la quantité d'information que l'on peut coder sur le dispositif d'identification par fréquence radio sans puce. On va ainsi pouvoir réaliser un plus grand nombre de résonateurs (ces derniers plus résonnant occuperont chacun une plus petite bande de fréquence chacun) pour une bande de fréquence donnée (par exemple 3 GHz - 10 GHz). Comme il y a un lien direct entre le nombre de résonateur et la capacité de codage, cette dernière va être augmentée au moins proportionnellement au nombre de résonateurs. Au-delà de la flexibilité, rapidité, précision et fiabilité de l'impression numérique, la présente invention permet donc également de modifier à souhait la signature RF du dispositif d'identification par fréquence radio sans puce non seulement grâce à la forme du motif conducteur mais également grâce à la sélection du type de produit d'impression et/ou grâce à l'épaisseur du produit d'impression. Cette caractéristique est extrêmement pertinente car ce contrôle/réglage est avantageusement combiné avec une connaissance exacte de l'épaisseur et de la conductivité de la pellicule conductrice puisque ces dernières sont constantes pour chaque rouleau de dorure sélectionné.

A titre illustratif, un papier classique a des pertes (exprimées en $\tan\delta$ - tangente de perte) que l'on exprime égales à 0.12. Hors, le vernis que l'on utilise a une $\tan\delta$ de 0.04. On voit en comparant les valeurs du papier à celle du vernis que si l'on augmente la proposition de champ dans le vernis par rapport au papier on diminue les pertes présentes au niveau de l'étiquette.

Une autre spécificité avantageuse du procédé et du dispositif revendiqués réside dans le fait que le motif imprimé numériquement est constitué par un produit d'impression (vernis/encre/toner) qui est compatible avec un grand nombre de supports. Contrairement à l'approche jet d'encre conducteur (approche non seulement coûteuse mais également impossible avec certains substrats au sein desquels l'encre conductrice risque de pénétrer ce qui engendre une épaisseur d'encre irrégulière et incontrôlable en surface), il est à présent possible de déposer le produit d'impression (vernis/encre/toner) sur un grand nombre de substrats, notamment le papier, le carton, le PET, etc.... En effet, quel que soit le substrat utilisé, on parvient grâce à la présente invention à obtenir une bonne résolution du motif imprimé et donc de la pellicule conductrice. Avec la méthode revendiquée, la couche métallique (pellicule conductrice) qui est la couche la plus sensible pour l'application (car il existe un lien direct entre la géométrie de cette couche et la signature RF de l'étiquette, c'est-à-dire son identifiant) va pouvoir être déposée toujours sur le même matériau, dans des conditions maîtrisées, et ceci quel que soit le support sur lequel l'étiquette va être positionnée.

Les capacités de codage obtenues au moyen des dispositifs d'identification par fréquence radio sans puce selon la présente invention répondent aux normes en vigueur car les étiquettes obtenues permettent d'avoir au moins

40 bits d'informations ce qui correspond au codes à barre de type EAN13. A titre illustratif, des valeurs de plus de 40 bits pour un format de carte de crédit [soit 40 / (85,60 × 53,98 mm)= 40/46 bits/cm$^2$] ont été obtenues ; ainsi, dans un mode d'exécution particulier selon la présente invention, les dispositifs revendiqués sont caractérisés par une valeur de capacité de codage supérieure à 0,85 bits/cm$^2$, par exemple supérieure à 1 bits/cm$^2$, supérieure à 2 bits/cm$^2$, voire supérieure à 5 bits/cm$^2$.

Un avantage additionnel du procédé et du dispositif revendiqués est qu'ils permettent la réalisation d'étiquettes multicouches. A titre illustratif et non limitatif, une impression conforme au procédé revendiqué selon la présente invention pourra avantageusement être réalisée en série après la fabrication d'un dispositif conforme à la présente invention. Un procédé d'impression multi-couches correspondant serait donc caractérisé par les étapes successives suivantes

- une étape d'impression numérique d'un motif par impression de produit d'impression,
- suivie d'une étape de dépôt sélectif de « dorure » conductrice sur le motif préimprimé par contact entre le produit d'impression et un film multi-couches comprenant une feuille conductrice, de préférence une feuille métallique conductrice.

Cette méthode est en particulier compatible avec la réalisation d'étiquettes sur des grandes surfaces (exemple en bobine-bobine) car la technologie revendiquée n'est ni limitée par le support ni même par les dimensions des pistes conductrices.

Dans un mode d'exécution particulier selon la présente invention, la technique de dorure a été optimisée de manière à favoriser de meilleures performances d'accroche de la feuille de dorure sur le substrat tout en améliorant la qualité et plus particulièrement la finesse du dépôt de dorure sur le substrat. Malgré l'évolution et la précision des techniques de dorure, la Demanderesse a constaté qu'il était très difficile de concilier ces deux conditions avec les techniques de dorure connues. Un des objectifs de la présente invention consiste donc également à fournir une technique de dorure particulière qui favorise de meilleures performances d'accroche de la feuille de dorure sur le substrat tout en améliorant la qualité et plus particulièrement la finesse du dépôt de dorure sur le substrat.

Ainsi, dans un mode d'exécution particulier, la présente invention utilise un procédé de dépôt de traces de matière conductrices sur un substrat dans une machine d'impression comprenant un poste d'impression suivi d'un poste de pose de film comprenant les étapes suivantes :

a. Fourniture du substrat,
b. Impression numérique d'un produit d'impression selon un motif sur le substrat,
c. Fourniture d'un film comprenant au moins une pellicule d'application comprenant une matière B, une pellicule de matière conductrice, et une couche de transport,
d. Application dans le poste de pose du film sur le substrat dans des conditions de pression et de température entrainant la co-adhésion sélective entre le produit d'impression du motif et la pellicule d'application du film,
e. Enlèvement du film du substrat,

e.1. le substrat comprenant la pellicule d'application du film co-adhérée au produit d'impression du motif et formant ainsi les traces de matière conductrice selon le dit motif,
e.2. le reste de la pellicule conductrice et, de préférence de la pellicule d'application, étant récupérée avec le film enlevé, tel que

- le produit d'impression comprend une matière A thermoplastique et, optionnellement, une matière thermodurcissable,
- la matière B de la pellicule d'application est thermoplastique,
- les matières A et B possèdent chacune une température de transition vitreuse Tg, et
- les conditions de l'étape d sont telles que les Tg de chacune des matières A et B sont atteintes et que des liaisons chimiques sont créées entre les matières A et B.

La température de transition vitreuse Tg peut être mesurée par toute méthode appropriée. Nous citerons à titre illustratif la calorimétrie à balayage différentiel (en anglais DSC pour Differential Scanning Calorimetry), qui est une méthode d'analyse thermique très reconnue dans le milieu pour mesurer différentes températures et états de transition.

A titre illustratif, l'échantillon polymère va être soumis à une rampe croissante de température de l'ordre de 10°C/min dont le flux de chaleur est mesuré en Watt. La température de transition vitreuse marque le passage de l'état vitreux de la matière à l'état caoutchouteux qui est un phénomène endothermique. Par conséquent, pour définir la valeur de la Tg, il suffit d'attendre l'observation d'une diminution du flux thermique en fonction de la température puis d'utiliser une méthode tangentielle. La valeur obtenue correspond à la Tg du polymère.

Sans vouloir être restreint par cette explication, la Demanderesse pense que la combinaison de ces caractéristiques de procédé/matières permet de répondre encore mieux aux objectifs cités ci-dessus dans la description ; à titre illustratif, le choix particulier des matières A (comme composant du produit d'impression (par exemple une encre, un vernis et/ou un toner)) et B (comme composant de la pellicule d'application) représente une caractéristique particulière de l'invention car ce choix induit un comportement thermoplastique de la pellicule d'application et du produit d'impression lors de leur mise en contact.

De plus, le procédé de fabrication correspondant se différencie de l'art antérieur grâce à sa souplesse d'utilisation et grâce à une réduction des temps de fabrication ainsi que des coûts correspondants, ce qui le rend particulièrement attractif pour la fabrication de dispositifs d'identification par fréquence radio sans puce.

Lorsque le produit d'impression est une encre ou un vernis, on favorisera dans le cadre de la présente invention les techniques d'impression par jet d'encre en relief du motif d'impression, par exemple à l'aide de têtes d'impression piézo-électriques, adaptées en fonction du produit d'impression (par exemple de l'encre et/ou vernis d'impression utilisé).

Les films utilisés dans le cadre de la présente invention comprennent de préférence au moins une pellicule d'application comprenant une matière B thermoplastique, une pellicule de matière conductrice et une couche de transport. L'homme de l'art dénomme généralement ce type de film par l'expression « feuille de dorure ». Ainsi, les feuilles de dorure (films) utilisées dans le cadre de la présente invention sont constituées de plusieurs pellicules superposées comprenant à titre d'exemple non limitatif :

- une pellicule d'application comprenant une matière B,
- au moins une pellicule de dorure/matière conductrice,
- une pellicule optionnelle de protection,
- une pellicule optionnelle de décollement, et
- au moins une couche de transport qui permet le transport des autres couches.

Les figures 1 à 3 illustrent certains modes de réalisation de la présente invention.

L'étape d'application du film sur le substrat dans des conditions de pression et de température entraînant la co-adhésion sélective entre le produit d'impression et la pellicule d'application du film (en particulier entre la matière A du produit d'impression et la matière B de la pellicule d'application du film) peut être effectuée selon toute méthode appropriée. A titre illustratif, on citera l'utilisation

- d'un ou plusieurs ensembles de rouleaux de pincement tels que décrits dans la figure 1 ;
- d'un ou plusieurs rouleaux de pression tels que décrits dans la figure 2.

La figure 3 illustre un mode de réalisation du procédé selon la présente invention avec le poste d'impression suivi du poste de dépose de film.

<u>FILM</u> - <u>composition et propriétés</u>

Les films utilisés dans le cadre de la présente invention sont de préférence constitués de plusieurs pellicules superposées comprenant à titre d'exemple non limitatif et non exhaustif dans l'ordre d'accroche au substrat à recouvrir :

- une pellicule d'application comprenant une matière B,
- suivie d'au moins une pellicule de matière conductrice,
- suivie d'une pellicule optionnelle de protection,
- suivie d'une pellicule optionnelle de décollement, et
- finalement suivie d'au moins une couche de transport qui permet donc le transport des autres couches.

Les films utilisés dans le cadre de la présente invention sont généralement fournis sous la forme de rouleau de largeur sensiblement équivalente à la dimension transversale du substrat.

**Couche de transport**

La couche de transport permet le transport des autres couches constitutives du film et, en particulier, de la pellicule de matière conductrice et de la pellicule d'application conformes à la présente invention. Son rôle est donc principalement celui de véhiculer les autres couches constitutives du film jusqu'à la dépose finale de la pellicule d'application et de la pellicule de matière conductrice conformes à la présente invention.

L'épaisseur de cette couche est généralement comprise entre 5 et 50 $\mu$m. Une épaisseur plus importante a tendance à limiter le transfert thermique nuisant au taux de transfert. Une épaisseur plus faible amène de nombreuses difficultés dans la gestion des tensions. A titre illustratif et non limitatif, la couche de transport peut être composée de

films de polyester (PET). Ces derniers peuvent être co-extrudés, de différentes structures, traités en surface, etc.

Les traitements de surfaces peuvent concerner du corona, du plasma, du silicone, de l'acrylique, du polyester, etc.

En fonction de leur nature, les films PET permettront un étalement plus ou moins performant ainsi qu'une adhésion différente avec les couches inférieures du film.

**Pellicule de décollement**

La pellicule de décollement (optionnelle mais préférée), plus reconnue sous le terme anglais de « release layer » (ou pellicule de libération) permet l'optimisation du détachement de la couche de transport du reste du film lors de son application. Le grammage de cette pellicule n'est généralement pas quantifiable puisque son épaisseur est de préférence inférieure à 0,1 μm.

Lors de l'application d'une certaine température et pression, le dépassement de sa température de fusion va fluidifier et vaporiser une partie de la couche créant ainsi un détachement. En fonction de sa nature, des traces de la pellicule de décollement vont se retrouver soit sur la couche de transport (par exemple le PET), soit sur la surface de la couche située en dessous, soit sur les deux couches.

Dans la présente invention, les restes de la pellicule de décollement se trouveront de manière préférentielle sur la couche de transport (par exemple le PET) afin de ne pas contaminer la surface de la pellicule de matière conductrice. Dans un mode particulier d'exécution selon la présente invention, la pellicule de décollement comprend et/ou est constituée de matière conductrice d'électricité, par exemple de polymères conducteurs ; en effet, dans ce mode particulier, toute contamination de la pellicule de matière conductrice par la pellicule de décollement n'aura pas d'influence néfaste sur la conductivité recherchée.

La pellicule de décollement peut aussi avantageusement comprendre ou être constituée de cires solubles dans des solvants, de cires en émulsion, de cires naturelles, de cires siliconées, et/ou de cires synthétiques, etc.

A titre illustratif et non limitatif, la pellicule de décollement peut être enduite par le biais des techniques d'impression classiques telles que l'héliogravure ou l'héliogravure reverse, et/ou la flexographie, etc.

**Pellicule de protection**

La pellicule de protection (optionnelle) est aussi appelée de laquage et/ou de couleur (car elle peut aussi comprendre tout type de colorant et/ou pigment et/ou agent de matage ou brillant). Cette pellicule de protection peut être caractérisée par de nombreuses propriétés en fonction de l'utilisation recherchée, que ce soit des propriétés de résistance chimique et/ou physique. Cette pellicule est le plus souvent composée de vernis bi-composant, de résines acryliques, de résines polyesters, de résines hydroxylées, et/ou de dérivées cellulosique, etc. Toutes ces familles de matières constitutives de la pellicule de protection sont en général des polymères organiques qui sont donc considérés comme des isolants. Ainsi, selon un mode particulier d'exécution de la présente invention, le film ne comprend pas de pellicule de protection afin de préserver les caractéristiques conductrices de la pellicule de matière conductrice et d'éviter ainsi son isolation. Dans un mode particulier d'exécution selon la présente invention, la pellicule de protection comprend et/ou est constituée de matière conductrice d'électricité, par exemple de polymères conducteurs ; en effet, dans ce mode particulier, la pellicule de protection n'aura pas d'influence néfaste sur la conductivité recherchée. L'épaisseur de cette couche avoisine habituellement le plus souvent des valeurs comprises entre 2 μm et 3 μm.

La majorité des films commerciaux possèdent une couche protective à base de polymères non conducteurs, ce qui les rend impropres à leur utilisation dans toute application où la conductivité est recherchée car il en résulte une impossibilité à faire circuler le courant électrique.

A titre illustratif et non limitatif, la pellicule de protection peut être enduite par le biais des techniques d'impression classiques telles que l'héliogravure ou l'héliogravure reverse, et/ou la flexographie, etc.

**Pellicule de matière conductrice**

Dans un mode particulier d'exécution selon la présente invention, le principal rôle recherché pour la pellicule de matière conductrice est donc sa conductivité. Cette dernière doit en effet atteindre des valeurs adaptées au marché des dispositifs d'identification par fréquence radio sans puce, en particulier des tags RFID sans puce. A titre illustratif, la pellicule de matière conductrice peut être caractérisée par une résistance de surface (sheet résistance en anglais) inférieure à 1 ohm par carré (en anglais ohm/sq). Cette résistance de surface peut être mesurée par toute méthode appropriée ; nous citerons à titre illustratif la méthode 4 pointes qui permet de réaliser cette mesure en utilisant un générateur qui envoie un courant entre les pointes 1 et 4, en simultané la tension circulant entre les pointes 2 et 3 est mesurée. Il suffit ensuite d'appliquer la loi d'Ohm Tension=Résistance/Intensité pour obtenir la résistance entre les pointes 2 et 3.

Cette pellicule peut donc avantageusement comprendre et/ou être constituée de toute matière conductrice d'électricité. Par exemple, cette pellicule peut être composée de divers métaux déposés par le biais de plusieurs techniques comme le sputtering, l'E-Beam, et/ou l'évaporation thermique sous vide, etc. Les métaux candidats à une telle application sont à titre illustratif le cuivre, l'argent, l'étain, le chrome, l'or, l'aluminium, et/ou les alliages, etc.

Ainsi, selon un mode d'exécution préféré de la présente invention, la matière conductrice de la pellicule de matière conductrice peut avantageusement comprendre et/ou être constituée de cuivre et/ou d'argent, et/ou d'étain et/ou de chrome et/ou d'or et/ou d'aluminium, et/ou d'alliages conducteurs.

L'épaisseur de la pellicule de matière conductrice dans la majorité des films commerciaux se situe en général en dessous de 100 nm, par exemple proche de 80 nm. Dans un mode d'exécution particulier selon la présente invention, la pellicule de matière conductrice a une épaisseur d'au moins 100 nm, au moins 150 nm, au moins 200 nm, au moins 250 nm, voire même au moins 500 nm afin d'assurer la conductivité désirée ; en général la dite épaisseur a comme limite supérieure 2 $\mu$m, par exemple moins de 1,5 microns, voire même moins de 1 micron ou moins de 0,75 microns. L'augmentation de l'épaisseur de la pellicule de matière conductrice au-delà de certaines valeurs peut effectivement engendrer des problématiques de fragilité du film car le matériau métallique n'est pas aussi flexible que la matrice organique composant un polymère.

Dans un mode d'exécution particulier selon la présente invention, la pellicule de matière conductrice comprend des polymères conducteurs. A titre illustratif et non limitatif, la pellicule de matière conductrice comprenant des polymères conducteurs peut être enduite par le biais des techniques d'impression classiques telles que l'héliogravure ou l'héliogravure reverse, et/ou la flexographie, etc.

Dans un mode d'exécution particulier selon la présente invention, la pellicule de matière conductrice est caractérisée par une résistance inférieure à 100 $\Omega$, par exemple inférieure à 50 $\Omega$, et de préférence inférieure à 5 $\Omega$. Cette résistance peut être mesurée par toute méthode appropriée ; nous citerons à titre illustratif l'utilisation d'un multimètre en mode Ohm. Ceci permet de mesurer la résistance d'une surface.

**Pellicule d'application**

La pellicule d'application qui est généralement absente dans la plupart des applications de film connues à ce jour dans le domaine de la dorure de motifs pré imprimés se réalisant à froid est indispensable dans la présente invention. Son épaisseur est généralement comprise entre 2 et 10 $\mu$m.

Une caractéristique essentielle de la présente invention réside dans le fait que la pellicule d'application comprend et/ou est constituée d'une matière B thermoplastique, par exemple un ou plusieurs polymères thermoplastiques. Dans un mode d'exécution particulier selon la présente invention, la pellicule d'application comprend au moins 50% en poids de la matière B thermoplastique, par exemple au moins 70% en poids, de préférence au moins 80% en poids. Cette matière B thermoplastique peut être constituée d'un ou plusieurs composants chimiques thermoplastiques, par exemple deux ou plusieurs résines/polymères thermoplastiques.

Selon un mode d'exécution particulier de la présente invention, la pellicule d'application comprend donc une matrice de matière B thermoplastique (par exemple de polymère thermoplastique B) et est caractérisée par une température de transition vitreuse Tg telle que cette pellicule soit

- sèche au toucher à température ambiante, et
- thermoréactivable, c'est-à-dire qu'elle possède un comportement thermoplastique à partir duquel la pellicule d'application (et à fortiori la matière B qu'elle contient) va devenir ductile/malléable et développer ainsi une propriété d'adhésion de surface lorsque la température de traitement (et en particulier la température d'application lors de l'étape d'application du film dans le poste de pose du film) est supérieure à cette Tg.

Ainsi, dans un mode d'exécution particulier de la présente invention, la matière B thermoplastique est caractérisée par une valeur de Tg comprise entre 0°C et 200°C, par exemple entre 40°C et 130°C, par exemple entre 40°C et 80°C. Si la matière B thermoplastique est constituée d'un mélange homogène de deux ou plusieurs composants chimiques thermoplastiques, la valeur de Tg individuelle de chacun de ces composants ne sera pas critique pour autant que la Tg du mélange réponde bien aux valeurs désirées ; ainsi, la matière B thermoplastique pourra s'accommoder de composants thermoplastiques ayant des Tg inférieurs à 40°C , voire inférieurs à 0°C et/ou supérieurs à 80°C, voire supérieurs à 130°C, pour autant que la Tg de la dite matière de mélange soit comprise dans la fourchette de valeurs idéales.

Dans un mode d'exécution particulier de la présente invention, en plus de la matière B, la pellicule d'application peut également comprendre d'autres matières telles que par exemple des matières inertes (par exemple des charges inorganiques). Comme ces autres matières ont en général peu d'influence sur la Tg de l'ensemble de la matière constituant la pellicule d'application, la Tg de la dite pellicule d'application est très proche de celle de la matière B.

Ainsi, dans un mode d'exécution particulier de la présente invention, la pellicule d'application est caractérisée

par une valeur de Tg comprise entre 0°C et 200°C, par exemple entre 40°C et 130°C, par exemple entre 40°C et 80°C. La mesure de la Tg de la pellicule d'application sera avantageusement effectuée au moyen de la méthode DSC indiquée ci-avant dans la description - l'échantillon utilisé pour la mesure pourra avantageusement provenir de la matière constituant la pellicule d'application avant la fabrication du film correspondant.

Selon un mode d'exécution particulier de la présente invention, la matrice de polymère thermoplastique (la matière B) de la pellicule d'application présente une affinité particulière avec la matière A du produit d'impression. Cette affinité peut se traduire de différentes manières dont nous citerons à titre illustratif :

- le fait que la matière B contienne et/ou est constituée d'une (ou de plusieurs) résine(s) appartenant à une nature chimique qui est également présente dans la matière A du produit d'impression ; à titre illustratif et non limitatif, cette nature chimique sera sélectionnée parmi un groupe nucléophile (comprenant de l'oxygène et/ou de l'azote), un groupe hydroxyle et/ou un groupe azoté ; et/ou
- qu'au moins une des résines soit présente à la fois dans la matière B du film d'application et dans la matière A du produit d'impression et soit une résine acrylique, par exemple une résine acrylique similaire et/ou identique ; et/ou
- qu'au moins une des résines soit présente à la fois dans la matière B du film d'application et dans la matière A du produit d'impression et soit une résine cétonique, par exemple une résine cétonique similaire et/ou identique ; et/ou
- qu'au moins une des résines soit présente à la fois dans la matière B du film d'application et dans la matière A du produit d'impression et soit une résine aldéhyde, par exemple une résine aldéhyde similaire et/ou identique ; et/ou
- qu'au moins un des ingrédients soit présent à la fois dans la matière B du film d'application et dans la matière A du produit d'impression et soit de type cellulosique : par exemple un ingrédient consistant en de l'acétate propionate de cellulose, et/ou de l'acétate butyrate de cellulose, et/ou de l'acétate de cellulose, et/ou de la nitrocellulose.

Selon un mode d'exécution particulier de la présente invention, la matrice de polymère thermoplastique (la matière B) de la pellicule d'application peut être un polymère en phase solvant ou en phase aqueuse.

Sans vouloir être restreint par cette explication, la Demanderesse pense que cette partie commune entre au moins un des composants de la matière A et un des composants de la matière B va permettre de créer une affinité chimique entre ces deux matières lors de leur mise en contact grâce à leurs caractéristiques intrinsèques et grâce aux conditions de mise en contact. Cette affinité est responsable de la dépose sélective puisque la pellicule d'application comprenant la matière B va se déposer seulement sur la matière A et non sur le reste du substrat. Un film qui n'intègrerait pas cette partie commune pourrait soit contaminer, soit se déposer entièrement sur tout le substrat de manière non sélective, soit ne pas se déposer de manière précise et sélective sur le motif du produit d'impression puisque le transfert ne sera pas opérationnel.

A titre illustratif et non limitatif, la pellicule d'application peut être enduite par le biais des techniques d'impression classiques telles que l'héliogravure ou l'héliogravure reverse, et/ou la flexographie, etc.

PRODUIT D'IMPRESSION, MATIERE A- composition et propriétés

Ainsi, dans un mode d'exécution particulier de la présente invention, le produit d'impression comprend une matière A thermoplastique, par exemple un polymère thermoplastique A, et en option, une matière thermodurcissable. Ce produit d'impression préimprimé sur le substrat est garant du design de la future dorure et donc du tag RFID sans puce. En fonction de sa composition, le film va ou non se transférer sur le substrat. Il est indispensable que le transfert entre le film et le motif préimprimé soit sélectif, c'est-à-dire seulement au niveau du motif (et donc du produit d'impression préimprimé) favorable au transfert et non directement sur le substrat.

A titre illustratif et non limitatif, ce produit d'impression peut être composé de toner et/ou d'encre et/ou d'un vernis ; il est de préférence diélectrique comme expliqué ci-dessus dans la description pour l'application tag RFID sans puce visée.

A titre illustratif et non limitatif, dans le cas d'un vernis, celui-ci peut être de nature solvantée, aqueuse ou UV. Lorsqu'il est de nature UV, il peut être réticulé à l'aide de LED et/ou de rayonnements UV.

Selon un mode d'exécution particulier et préféré de la présente invention, le produit d'impression est de type encre UV et/ou vernis UV comprenant une matière à vocation thermodurcissable ainsi que la matière thermoplastique A. C'est la présence de cette matière à vocation thermodurcissable qui caractérise le fait que l'encre/vernis correspondant présente un comportement thermodurcissable. Selon un mode d'exécution particulier et préféré de la présente invention, le produit d'impression préimprimé (et donc le motif préimprimé) est réticulé avant mise en contact avec le film. Cela peut se traduire par le fait que le réseau polymérique du produit d'impression est à son optimum en termes de densité tridimensionnelle par le biais de la réaction de tous les sites de photo-initiateurs. Cela peut également se traduire par un comportement thermodurcissable, c'est-à-dire que la partie thermodurcissable du vernis ne possède plus de température de transition vitreuse Tg mais seulement une température de destruction ; ainsi, ce polymère thermodurcissable présent dans le vernis ne deviendra jamais mou et ne développera pas de surface collante car il sera totalement sec

au touché.

Ainsi, selon certains modes de réalisation préférés de la présente invention, le procédé revendiqué comprend, après l'étape d'impression du produit d'impression et avant l'étape d'application du film, une étape d'activation (par exemple au moyen de rayons UV) permettant de réticuler le produit d'impression (l'encre et/ou le vernis).

L'ajout dans le produit d'impression d'une matière A thermoplastique permet d'atteindre les objectifs d'accroche sélective entre le substrat et le film. A titre illustratif pour une encre et/ou un vernis, la sélection d'une matière A, la dite matière A appartenant à une nature chimique analogue à la matière B présente dans la pellicule d'application du film et/ou la dite matière A présentant des propriétés physiques (par exemple les Tg) adaptées à celles de la matière B présente dans la pellicule d'application du film, va modifier le comportement du produit d'impression ; ce dernier va devenir en partie thermoplastique puisque la matière A thermoplastique va s'immiscer dans le réseau polymère à vocation initiale thermodurcissable. Ainsi, lors de l'application du film sur le produit d'impression préimprimé et, de préférence pré-réticulé, un transfert total et sélectif va s'opérer par le biais de l'affinité des matières A et B et grâce aux conditions de mise en contact. Ces constations sont également applicables lorsqu'on sélectionne le toner en lieu et place des encres/vernis ; toutefois, dans le cas particulier du toner, la Demanderesse a constaté que la présence de matière thermodurcissable, même si elle était souhaitable, n'était pas indispensable pour obtenir l'adhésion entre la pellicule d'application et le toner.

Un dépôt de couches conductrices sélectif peut donc se réaliser grâce, entre autres, à cette affinité entre la matière A et la matière B. Ainsi, tout dispositif comprenant ces couches de produits d'impression et de films conducteurs selon la présente invention seront également caractérisés par l'existence d'une couche interstitielle comprenant de la matière du produit d'impression et de la matière de la pellicule d'application du film.

Ainsi, selon un mode d'exécution de la présente invention, la matière thermoplastique A du produit d'impression est

- thermoréactivable (c'est-à-dire qu'elle possède un comportement thermoplastique), et

- devient ductile/malléable et développe une propriété d'adhésion de surface lors de l'étape d'application du film dans le poste de pose du film (lui-même thermoréactivable).

Ceci permet donc de développer une propriété d'adhésion de surface entre le produit d'impression et la pellicule d'application grâce aux matières A et B lorsque la température de traitement (et en particulier la température d'application du film lors de l'étape d'application du film dans le poste de pose du film) est supérieure aux Tg des matières thermoplastiques A et B et/ou supérieure aux Tg des produits d'impression imprimés/(réticulés) et de la pellicule d'application du film de dorure.

Dans un mode d'exécution particulier selon la présente invention, le produit d'impression, de préférence de type encre/vernis, comprend au moins 5% en poids de matière A thermoplastique, par exemple au moins 10 % en poids, de préférence au moins 15% en poids. Même si des concentrations élevées en matière A thermoplastique sont envisageables, le produit d'impression, de préférence de type encre/vernis, comprendra de préférence moins de 40% en poids, par exemple moins de 30% en poids, de préférence moins de 25% en poids de matière A thermoplastique.

Ainsi, dans un mode d'exécution particulier selon la présente invention, le produit d'impression, de préférence de type encre/vernis, comprend au moins 60% en poids, par exemple au moins 70% en poids, de préférence au moins 75% en poids de matière à vocation thermodurcissable.

Ainsi, dans un mode d'exécution de la présente invention particulièrement applicable aux vernis/encres, la matière A thermoplastique est caractérisée par une valeur de Tg inférieure à 60°C, par exemple inférieure à 50°C, de préférence inférieure à 40°C. Selon un mode d'exécution particulier de la présente invention, et comme décrit plus en détails ci-après dans la description, les matières A du produit d'impression de type encre/vernis et B de la pellicule d'application seront sélectionnées de manière à ce que la Tg de la matière A soit inférieure à la Tg de la matière B.

Comme le produit d'impression de type encre/vernis ne comprend que des quantités limitées de matière A thermoplastique, il est évident que la Tg du produit d'impression aura après dépôt (et réticulation) une valeur qui sera différente de la Tg de la matière A thermoplastique comprise dans ledit produit. Lorsque le produit d'impression est un toner, sa teneur en matière thermoplastique est en général supérieure 30% en poids, supérieure à 40% en poids, voire supérieure à 50% en poids.

Dans un mode d'exécution particulier de la présente invention, le produit d'impression est une encre ou un vernis. Après dépôt/réticulation, ce produit d'impression imprimé destiné à être recouvert d'une feuille de dorure se trouve sous la forme d'une pellicule qui est avantageusement caractérisée par une valeur de Tg comprise entre -20°C et 200°C, par exemple entre 0°C et 200°C, par exemple entre 10 et 50°C, par exemple entre 15°C et 40°C.

Dans un mode d'exécution particulier de la présente invention, le produit d'impression est un toner. Après dépôt, par exemple par xérographie, ce produit d'impression imprimé destiné à être recouvert d'une feuille de dorure se trouve sous la forme d'une pellicule qui est avantageusement caractérisée par une valeur de Tg comprise entre 0°C

et 200°C, par exemple entre 40°C et 120°C, par exemple entre 40°C et 70°C.

La mesure de la Tg de la pellicule du produit d'impression imprimé/(réticulé) (vernis/encre/toner) sera avantageusement effectuée au moyen de la méthode DSC indiquée ci-avant dans la description - l'échantillon utilisé pour la mesure pourra avantageusement provenir de la matière constituant le produit d'impression après impression et réticulation. Selon un mode d'exécution particulier de la présente invention, et comme décrit plus en détails ci-après dans la description, le produit d'impression et la pellicule d'application seront de préférence caractérisés en ce que la Tg du produit d'impression de type encres/vernis soit inférieure à la Tg de la pellicule d'application.

IMPRESSION DU MOTIF - conditions

La présente invention est donc caractérisée en ce que le procédé revendiqué permet l'obtention d'un substrat comprenant la pellicule d'application du film sélectivement co-adhérée au produit d'impression du motif et formant ainsi, grâce à la pellicule de matière conductrice, les traces de matière conductrice selon le dit motif. Le dit motif (du produit d'impression) peut être imprimé par toute méthode appropriée. On citera à titre illustratif et non limitatif la sérigraphie, le jet d'encre, la xérographie, etc... Selon un mode d'exécution particulier et préféré de la présente invention, le produit d'impression est imprimé numériquement, par exemple par une impression jet d'encre ou une impression par xérographie, de préférence par une impression jet d'encre. Cette impression jet d'encre permet d'imprimer en relief des zones destinées à être recouvertes ou non, en fonction de la composition du produit d'impression et plus particulièrement de la présence ou non de la matière A, par la pellicule de matière conductrice (par exemple le film de dorure). La dorure se déposera donc de manière sélective. L'impression par jet d'encre de vernis/encre est bien connue de l'Homme de l'art. L'impression par xérographie de toner est également bien connue de l'Homme de l'art

Les zones (et donc le motif) peuvent avantageusement être toutes sortes de formes géométriques quelconques adaptées à la génération des tag RFID sans puce; elles peuvent être théoriquement constituées de différentes matières, par exemple d'encres et/ou de vernis et/ou de toner, même s'il est préférable de n'utiliser qu'un seul type de produit d'impression diélectrique lors de la fabrication du dispositif RFID sans puce.

L'épaisseur du produit d'impression imprimé peut avantageusement être très variable ; on citera à titre illustratif et non limitatif une épaisseur de la pellicule de produit d'impression (encre/vernis/toner) déposé (et mesurée juste avant la mise en contact avec le film) supérieure à 3 microns, par exemple de plus de 10 microns ; et/ou une épaisseur de la pellicule de produit d'impression (encre/vernis/toner) déposé (et mesurée juste avant la mise en contact avec le film) inférieure à 200 microns, par exemple de moins de 100 microns. A chaque fabrication d'un batch de dispositifs RFID sans puce conforme à la présente invention, on favorisera la sélection d'une valeur unique d'épaisseur du produit d'impression imprimé afin de pouvoir augmenter les cadences d'impression et de dorure ; à titre illustratif, on tolérera ainsi des écarts maximum de 10% autour d'une épaisseur sélectionnée.

En fait, le relief des motifs et donc des zones destinées à être recouvertes d'une feuille de dorure représente de préférence une épaisseur de l'ordre du micron, de préférence supérieure à cinq microns, ou même supérieure à dix microns. Cette épaisseur - de quelque matière que ce soit préalablement déposée sur le substrat ; par exemple du vernis et/ou de l'encre et/ou du toner - est généralement inférieure au millimètre pour l'impression en relief. Toutefois, la présente invention pourrait également s'appliquer à des substrats ayant été imprimés par la technologie 3D, par exemple au moyen d'impression à jet d'encre (et/ou vernis) par couches successives et présentant ainsi des épaisseurs pouvant aller jusqu'à plusieurs centimètres, par exemple moins de 2 cm.

Le substrat peut être sélectionné parmi un grand nombre de matière et ne pas être considéré comme limité aux matières fréquemment utilisées dans les dispositifs standards d'impression et/ou de personnalisation tels que les substrats papier, carton et plastique. On citera à titre d'exemples non limitatifs le métal, le papier, le tissu non tissé, le plastique, par exemple une résine copolymère méthacrylique, du polyester, du polycarbonate, du polyéthylène, du polypropylène, et/ou du chlorure de polyvinyle, ou même les matériaux de type cellulosique tels que, par exemple, le bois, le contreplaqué ou les matériaux cristallins tels que le verre ou les céramique, par exemple les matériaux complexes comprenant un ou plusieurs de ces composants comme par exemple les briques de lait.

Selon la présente invention, le substrat (feuille, carte, etc.) se présente généralement sous une forme rectangulaire ou carrée. Cette feuille se déplace, en général grâce à un système de transport de substrats dans une machine d'impression, le long d'un chemin de transport orienté selon un axe longitudinal depuis au moins un magasin d'entrée fournissant les substrats imprimables et/ou personnalisables, jusqu'à au moins un magasin de sortie recevant les substrats imprimés et/ou personnalisés, et donc recouverts des traces de matière conductrice conformément à la présente invention. Les « bords latéraux » du substrat sont les deux bords situés de part et d'autre de cet axe longitudinal; les bords avant et/ou arrière sont ses bords transversaux. Le substrat peut également se présenter sous la forme de bobine dans une machine de type bobine-bobine.

APPLICATION DU FILM

L'étape d'application du film sur le substrat dans des conditions de pression et de température entrainant la co-adhésion sélective entre le produit d'impression et la pellicule d'application du film (en particulier entre la matière A du produit d'impression et la matière B de la pellicule d'application du film) peut être effectuée selon toute méthode appropriée. A titre illustratif, on citera l'utilisation

- d'une ou plusieurs plaques qui viennent presser le film sur le substrat ;
- d'un ou plusieurs ensembles de rouleaux de pincement tels que décrits dans la figure 1 ;
- d'un ou plusieurs rouleaux de pression tels que décrits dans la figure 2.

Cette étape est donc importante car elle conditionne le positionnement des traces de matière conductrice sur le substrat.

Les conditions de pression et de température seront donc avantageusement sélectionnées en fonction des matières A et B utilisées respectivement dans le produit d'impression et dans la pellicule d'application.

A titre illustratif, la température d'application du film est avantageusement située entre 0°C et 200°C, par exemple entre 70°C et 190°C, par exemple entre 130°C et 170°C. Dans un mode d'exécution particulier de la présente invention, la température d'application du film sera également sélectionnée en fonction du temps de contact pendant lequel le produit d'impression et la pellicule d'application sont mis en contact et chauffés. Comme on essaye de favoriser des temps de contact relativement courts (par exemple inférieurs à la seconde), on a constaté que la température d'application du film devait avantageusement être supérieure d'au moins 25°C à la Tg la plus grande de la pellicule d'application et de la pellicule de vernis/encre/toner, par exemple au moins 40°C supérieure à cette Tg, voire même au moins 60°C supérieure à cette Tg.

La présente invention est également décrite de manière illustrative et selon un de ses modes de réalisation particulier dans la figure 3. On peut y voir sur la partie gauche de la figure, un groupe de dorure conforme à la présente invention et qui se trouve en aval du poste d'impression représenté sur la partie droite de la figure. Le substrat se déplace donc de droite à gauche. A titre illustratif, le substrat peut avantageusement être constitué de papier, de carton plat, de carton ondulé et/ou micro-ondulé et/ou de plastique. Il peut être sous forme de bobine - bobine ou de feuille à feuille. Lorsque le substrat passe sous le poste d'impression qui peut être un cylindre, un écran sérigraphique, et/ou des têtes jets d'encre, etc, le motif souhaité est imprimé par un vernis/une encre ou du toner contenant la matière A. Dans le cas de têtes jet d'encre, le vernis doit être adapté à ce type d'application en disposant d'une très basse viscosité. L'épaisseur imprimée peut avantageusement varier de 5 $\mu$m à 100 $\mu$m dans la majorité des cas ; toutefois, comme expliqué ci-dessus dans la description, on préfèrera maintenir cette épaisseur autour d'une valeur sélectionnée lors de la fabrication d'un batch de tag RFID sans puce.

Par la suite, le motif imprimé (encre/vernis) est avantageusement réticulé au maximum de sa densité tridimensionnelle de ce que permet sa structure et ses sites de réaction ; ceci peut se faire par un moyen de séchage (comme représenté au centre de la figure) tel que séchage physique, IR, rayonnements UV, LED, etc. Le motif imprimé est en général après cette étape de séchage/réticulation non collant en surface.

Le groupe de dorure est dans cette illustration constitué d'au minimum deux rouleaux (de préférence motorisés), installés en vis-à-vis, tournant par exemple en sens contraire, et dont la distance est réglable de façon à s'adapter à différentes épaisseurs de substrats ; selon un mode d'exécution préféré de la présente invention, ce réglage tiendra compte non seulement de l'épaisseur du substrat mais également de l'épaisseur du produit d'impression (par exemple de l'encre et/ou du vernis) préalablement imprimé sur le substrat ainsi que de manière optionnelle en tenant compte des épaisseurs du film et donc des pellicules de la feuille de dorure déposées par le groupe de dorure. Selon un mode d'exécution particulier de la présente invention, l'écartement entre les rouleaux en vis-à-vis peut être motorisé et commandé de façon dynamique. Selon un mode d'exécution particulier et préféré de la présente invention, la surface du rouleau supérieur est différente de celle du rouleau inférieur ; en particulier, la surface du rouleau supérieur est plus compressible que celle du rouleau inférieur. A titre illustratif, le rouleau supérieur présente en surface une matière compressible lui permettant d'épouser la forme du motif imprimé du produit d'impression alors que le rouleau inférieur sera constitué d'une matière plus dure, par exemple incompressible. Selon un mode d'exécution particulier de la présente invention, le rouleau supérieur comporte un dispositif de chauffage (et/ou de refroidissement) permettant non seulement d'atteindre les températures de transition vitreuse Tg de chacune des matières A et B mais également les températures de transition vitreuse Tg du produit d'impression imprimé/(réticulé) et de la pellicule d'application du film de dorure.

Selon un mode d'exécution particulier de la présente invention, le groupe de dorure (ou d'application du film) fonctionne avec une vitesse linéaire (en surface des rouleaux) supérieure ou égale à la vitesse du substrat sous le poste d'impression de façon à ne pas ralentir la machine.

Les caractéristiques de contrôle du groupe de dorure sont données ci-après à titre illustratif : pression réglable (par exemple de 1 à 10 bars, de préférence avec une pression de fonctionnement supérieure à 1 bar), et/ou vitesse

réglable ; et/ou température réglable (par exemple une température de fonctionnement de maximum 250°C, par exemple comprise entre 0°C et 200°C, par exemple entre 70°C et 190°C, par exemple entre 130°C et 170°C,; et/ou dureté du revêtement du rouleau supérieur comprise entre 50 et 95 Shore A.

Le passage du motif imprimé (et réticulé) sous les rouleaux va permettre de chauffer le motif préimprimé contenant la matière A au-delà de la Tg de la matière A et du produit d'impression imprimé/(réticulé) comprenant la dite matière A. Le caractère thermoplastique de la matière A va permettre un ramollissement de celle-ci. Il en est de même pour la matière B de la pellicule d'application. Les deux matières ainsi ramollies peuvent être considérées comme « ouvertes », permettant ainsi l'adhésion d'une matière analogue. Les groupements libres (par exemple hydroxylés) de chaque matière ainsi que les insaturations vont développer des liaisons chimiques de type covalente entre les matières. Ainsi, l'accroche de la matière B sur la matière A sera favorisée tout en évitant une quelconque accroche de la pellicule d'application sur les parties de substrat non préimprimées. La dépose sera ainsi dite « sélective ».

Dans un mode d'exécution particulier selon la présente invention, le décollement du foil (du film) du substrat se réalise idéalement lorsque le film est encore chaud afin d'être dans les meilleures conditions de transfert possible. La présence d'un angle ouvert lors du pelage du film permet d'obtenir une bonne finesse en évitant des contours mal définis.

Une composition particulière de film pouvant avantageusement être utilisé dans le cadre de la présente invention est décrite ci-dessous à titre illustratif et non limitatif.

Une couche de transport constituée de PET d'épaisseur de préférence comprise entre 15 $\mu$m et 24 $\mu$m (par exemple de 19 $\mu$m), ce qui représente le meilleur compromis entre les propriétés mécaniques et sa faculté à conduire la chaleur lors de l'application du film.

Une pellicule de décollement avantageusement constituée de cire, par exemple d'une cire naturelle type carnauba, avec un point de fusion de préférence compris entre 60°C et 110°C (par exemple situé aux alentours de 85°C). Ainsi, suivant les conditions énoncées précédemment, lorsque la température d'application du film va atteindre les 120-140°C lors du dépôt, la cire sera vaporisée. Celle-ci étant le lien très fin (échelle nanométrique) entre les couches du film, sa transformation d'état va induire un détachement de la couche de transport vis-à-vis du reste du film.

La pellicule de protection optionnelle peut avantageusement être composée de polymères acryliques hydroxylés de type PMMA et dérivés. La technologie repose le plus souvent sur la réaction bi composante des polymères hydroxylés avec des résines comportant des groupes isocyanates. Cette réaction va permettre de densifier le réseau polymérique dans l'optique d'améliorer les propriétés de résistance mécanique et chimique. Pour que cette couche soit conductrice des polymères de type PEDOT:PSS sont avantageusement introduits dans la matrice (voir exemple ci-dessous).

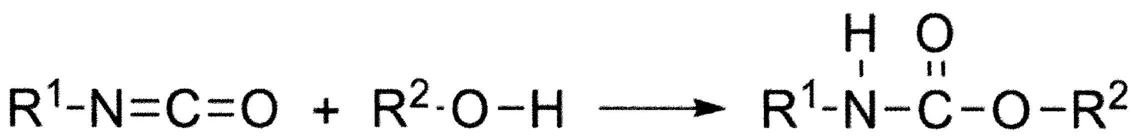

Isocyanate Polyol Polyuréthane

Avec R1 et R2 étant des chaines hydrocarbonées plus ou moins longues.

Une composition de 50% d'acrylique PMMA, 20% d'isocyanate et 30% de PEDOT:PSS est un bon équilibre afin d'obtenir les propriétés de résistance et de conductivité visées.

La pellicule de matière conductrice peut avantageusement être constituée d'argent, de cuivre et/ou d'aluminium. La matière conductrice peut être composée d'un dépôt d'épaisseur comprise entre 100 nm et 1 $\mu$m, par exemple entre 150 nm et 750 nm, par exemple entre 200 nm et 500 nm, déposé par une technique PVD. Cette méthode d'évaporation sous vide est une technique de dépôt de couche mince, la matière vaporisée va venir se déposer de manière homogène sur le film/substrat. La valeur de résistance obtenue pour cette pellicule de matière conductrice peut avantageusement se situer entre 0.1 $\Omega$ et 100 $\Omega$. L'épaisseur de la pellicule de matière conductrice sera sélectionnée en fonction des applications recherchées ; la Demanderesse est parvenue à développer son procédé avec des épaisseurs de pellicule de matière conductrice allant de 50 nm à l'ordre du micron. Des épaisseurs de plus de 100 nm, par exemple de plus de 150 nm, 200 nm, 300 nm, 400 nm, 500 nm ont été avantageusement réalisées et testées dans le cadre de la présente invention. Ainsi, comme expliqué ci-dessous dans l'application d'étiquettes d'identification par fréquence radio (RFID) sans puce, l'obtention d'épaisseurs de pellicule de matière conductrice supérieures à 150 nm, supérieures à 250 nm, voire supérieures à 400 nm ou même supérieures à 500 nm, a ouvert la voie à ces nouvelles applications.

La pellicule d'application (comprenant et/ou constituée par la matière B) peut avantageusement être composée de résines acrylique et polyester hydroxylées, ainsi que de nitrocellulose et de charges. L'avantage que les résines acrylique et polyester soient hydroxylées et/ou carboxylées est la création de sites d'accroches favorisant les liaisons

chimiques avec une interface mise en contact type matière A (provenant du produit d'impression). Une formule performante peut être composée de 40% de résine acrylique hydroxylée, 30% de résine polyester hydroxylée, 20% de nitrocellulose et 10% de charges type silice (%tage en poids). La formule finale sera de préférence une phase solvant d'extrait sec entre 15 et 30% en poids appliquée par rotogravure. Il est judicieux d'obtenir une Tg de la matière B dans une plage comprise entre 40 et 80°C.

Le produit d'impression peut-être avantageusement un vernis jet d'encre UV. Sa principale caractéristique est une faible viscosité comprise entre 5 mPa.s et 70 mPa.s, par exemple entre 10 mPa.s et 50 mPa.s. Il peut être composé de plusieurs monomères comme le dipropylène glycol dyacrilate (DPGDA), le trimethylolpropane triacrylate (TMPTA), la partie monomère représentant de préférence au moins 50% en poids de la composition du produit d'impression, par exemple 60% en poids. La partie photo initiateurs qui permet d'initier la réticulation est de préférence comprise entre 10 et 25% en poids de la composition du produit d'impression, par exemple de l'ordre 20% en poids ; elle est avantageusement composée d'alpha-hydroxy-cyclohexyl-phenyl-ketone et d'alpha-hydroxy ketone. La matière A est de préférence comprise entre 15 et 30% en poids de la composition du produit d'impression, par exemple 20% en poids ; il peut s'agir d'une résine acrylique hydroxylée dont la Tg est assez basse, par exemple inférieure à 50°C, par exemple inférieure à 40°C ou même inférieure à 20°C.

L'objectif est donc de réactiver à la fois le produit d'impression imprimé/(réticulé) ainsi que la pellicule d'application lors de leur mise en contact en dépassant leur température Tg respective; cela permet de générer des accroches entre les deux matières et permettre l'adhésion recherchée, par exemple grâce aux groupes hydroxyles de la résine de la matière A et de la matière B.

Dans un mode d'exécution particulier concernant plus particulièrement les vernis/encres, on réactive dans un premier temps le produit d'impression imprimé/réticulé dès que la montée en température atteint la Tg du dit produit d'impression imprimé/réticulé ; ensuite, la température atteint la Tg de la pellicule d'application ce qui permet l'adhésion entre le produit d'impression et la matière B de la pellicule d'application.

INTERACTIONS MATIERE A ET MATIERE B

Une gamme de températures susmentionnée permet de ramollir légèrement les matières A et B et, en particulier les produits d'impression et la pellicule d'application, grâce au dépassement de leur température de transition vitreuse Tg respective. Ces conditions seront sélectionnées pour permettre la création de liaisons chimiques entre les matières A et B et donc l'accroche améliorée et sélective entre le substrat et le film ; ces conditions seront également contrôlées de manière à éviter toute excursion/montée en température ce qui permet d'éviter

- que la matière B présente dans la pellicule d'application (et également la pellicule elle-même) ne devienne trop collante/fondue ; ce qui permet d'éviter toute adhésion de la pellicule d'application directement sur le substrat dans les zones non préimprimées de produit d'impression comprenant la matière A,
- que la matière A (et également le produit d'impression imprimé/réticulé lui-même) ne devienne trop collante/fondue ; ce qui permet d'éviter que le motif d'impression ne perde sa finesse et engendre des traces de matière conductrice trop grossières et donc inutilisables.

Selon un mode d'exécution particulier de la présente invention, mode d'exécution particulièrement pertinent pour les vernis/encres, les matières A du produit d'impression et B de la pellicule d'application seront sélectionnées de manière à ce que la Tg de la matière A (Tg[A]) soit inférieure à la Tg de la matière B (Tg[B]) ; de préférence, Tg[A] sera inférieure à 0,9 Tg[B], voire inférieure à 0,8 Tg[B], par exemple inférieure à 0,7 Tg[B], par exemple inférieure à 0,5 Tg[B].

Selon un mode d'exécution particulier de la présente invention, mode d'exécution particulièrement pertinent pour les vernis/encres, les matières A du produit d'impression et B de la pellicule d'application seront sélectionnées de manière à ce que la Tg du produit d'impression (imprimé/réticulé) contenant la matière A soit inférieure à la Tg de la pellicule d'application contenant la matière B ; de préférence, Tg (produit d'impression (imprimé/réticulé)) sera inférieure à 0,95 Tg (pellicule d'application), voire inférieure à 0,9 Tg(pellicule d'application), par exemple inférieure à 0,85 Tg (pellicule d'application).

Selon un mode d'exécution particulier de la présente invention, mode d'exécution particulièrement pertinent pour les toners, les matières A du produit d'impression et B de la pellicule d'application seront sélectionnées de manière à ce que la différence de température entre la Tg du produit d'impression (imprimé) contenant la matière A et la Tg de la pellicule d'application contenant la matière B soit de moins de 30°C, et ceci, par exemple, dans un intervalle de valeurs de températures comprises entre 35°C et 75°C.

Selon un mode d'exécution particulier de la présente invention, les matières A du produit d'impression et B de la pellicule d'application seront sélectionnées de manière à ce qu'elles comprennent une nature chimique identique ; à titre illustratif et non limitatif, cette nature chimique sera sélectionnée parmi un groupe nucléophile (comprenant de l'oxygène et/ou de l'azote), un groupe hydroxyle et/ou un groupe azoté. Ceci favorisera la création de liaisons chimique

de type covalente supérieure à 200 kJ/mol entre les atomes afin de favoriser l'adhésion entre les surfaces du produit d'impression imprimé/réticulé et de la pellicule d'application.

Selon un mode d'exécution particulier de la présente invention, la Demanderesse a découvert de manière inattendue qu'il était possible d'optimiser les performances de dépôt de son procédé en contrôlant la température du produit d'impression après impression et avant application du film. Ainsi, dans une mode d'exécution préféré selon la présente invention une ou plusieurs des conditions citées ci-dessous est appliquée au procédé revendiqué

- la température de produit d'impression imprimé entre l'étape d'impression du dit produit et l'étape d'application du film est maintenue à une valeur supérieure à 35°C, par exemple supérieure à 40°C, de préférence supérieure à 45°C ; et/ou
- la température de produit d'impression imprimé et réticulé entre l'étape de réticulation du dit produit imprimé et l'étape d'application du film est maintenue à une valeur supérieure à 35°C, par exemple supérieure à 40°C, de préférence supérieure à 45°C.

Toutefois, même si cela ne représente pas un mode d'exécution préféré, il est évident que le procédé selon la présente invention couvre également le cas où l'étape d'application du film se ferait de manière déportée (dans le temps ou l'espace) par rapport à l'étape d'impression du produit d'impression.

Selon un mode d'exécution particulier de la présente invention, le procédé revendiqué comprend également un procédé de dépôt de traces de matière conductrice qui comprend également un procédé d'impression de traces isolantes en un seul passage dans la machine d'impression. Ainsi, le procédé revendiqué comprend non seulement l'impression d'un motif de premier produit d'impression comprenant la matière A conformément aux objectifs d'accroche de pellicule d'application et donc de matière conductrice précités mais également l'impression d'un deuxième produit d'impression différent du premier produit d'impression utilisé ; ce deuxième produit d'impression sera sélectionné de manière à lui conférer une propriété isolante en terme de conduction électrique. Au-delà de sa propriété d'isolant, le deuxième produit d'impression sera sélectionné de manière à empêcher toute accroche avec la pellicule d'application du film ; ainsi, à titre illustratif, le deuxième produit d'impression ne comprend de préférence ni la matière A, ni aucune autre matière similaire à la matière A en terme de nature chimique et/ou propriétés physico-chimiques de manière à éviter l'affinité avec la matière B de la pellicule d'application. A titre illustratif et non limitatif, le deuxième produit d'impression sera sélectionné parmi les vernis thermodurcissables (ou à vocation thermodurcissable), de préférence UV-thermodurcissables - ils seront de plus de préférence exempts de tout polymère thermoplastique de Tg égale ou inférieure à la température d'application du film sur le substrat. Ce type de procédé grâce à l'utilisation d'un vernis foilable (conducteur et/ou isolant) et non foilable (conducteur et/ou isolant) ouvre un champ d'application intéressant pour l'électronique imprimée avec la possibilité d'imprimer des traces isolantes et/ou conductrices en un passage dans la machine d'impression en fonction du besoin client.

## INKJET CONDUCTEUR EN SERIE

Selon un mode d'exécution particulier de la présente invention, le procédé revendiqué comprend non seulement une étape d'impression de motif, suivie de l'étape de dépôt de traces de matière conductrice selon le dit motif, mais il comprend également une étape additionnelle subséquente d'impression jet d'encre de produit d'impression conducteur au moins en partie sur les traces ou exclusivement sur les dites traces de matière conductrice déposée. Ainsi, à titre illustratif, la présente invention permet aussi de rajouter un vernis conducteur jet d'encre en surface de la trace conductrice après l'application de la pellicule de matière conductrice. L'avantage de ce vernis conducteur est multiple puisqu'il va permettre de préserver une conductivité élevée tout en apportant les propriétés de résistance mécanique et chimique d'un vernis de surface. Il s'intègre pleinement dans les problématiques observables dans le domaine de l'électronique imprimée.

Ce produit d'impression additionnel peut avantageusement être sélectionné parmi les vernis composés de polymères conducteurs tels que le polypyrrole, la polyaniline, le PEDOT:PSS, le polyacétylène et leurs dérivés, etc. L'ajout de charges métalliques ou carbonées afin d'améliorer cette conductivité est également possible. On citera également à titre illustratif des encres conductrices à base de nanoparticules conductrices comme des nanoparticules d'argent, de cuivre et/ou d'or.

Ces composés conducteurs peuvent être de différentes natures solvantés, aqueux ou UV ; leur séchage peut également être par rayonnement UV ou LED ou par séchage thermique ou IR.

## ÉTIQUETTE RFID SANS PUCE

Le procédé d'impression/dorure décrit et détaillé ci-dessus s'est avéré particulièrement attractif et efficace pour la fabrication d'étiquettes d'identification par fréquence radio (RFID) sans puce (aussi appelés tags RFID sans puce)

de la présente invention. Ces étiquettes d'identification par fréquence radio sont donc caractérisées par la génération d'un code d'identification lisible par un émetteur-récepteur d'ondes électromagnétiques. On citera à titre illustratif la fabrication d'étiquette RFID sans puce comprenant une géométrie particulière de chemins conducteurs réalisés au moyen du procédé décrit et revendiqué conformément à la présente invention (avec la pellicule de matière conductrice) ; cette géométrie particulière de chemins conducteurs d'électricité sera à titre illustratif constituée d'une pluralité de bandes conductrices parallèles disjointes formées sur un support diélectrique (vernis/encre/toner), dans laquelle des ponts conducteurs relient entre elles des bandes conductrices voisines, les ponts conducteurs délimitant, entre les bandes conductrices, des portions de bandes diélectriques de longueurs distinctes, chaque portion de bande diélectrique déterminant une fréquence de résonance de l'étiquette, l'ensemble des fréquences de résonance de l'étiquette définissant un code d'identification lisible par un émetteur-récepteur d'ondes électromagnétiques. Dans un exemple préféré de réalisation, la géométrie des chemins conducteurs sera donc avantageusement réalisée sur n'importe quel substrat au moyen d'une technologie d'impression sans contact (par exemple impression numérique par jet d'encre d'encre/vernis, par exemple au moyen de têtes d'impression de type piézoélectrique, ou impression numérique par xérographie du toner) du produit d'impression (par exemple isolant) suivi de la technologie de dorure de matière conductrice d'électricité. Les ponts et bandes susmentionnés seront donc avantageusement réalisés au moyen de la même feuille de dorure. Pour rappel, dans un mode d'exécution particulier selon la présente invention, la fabrication d'étiquette RFID sans puce selon le procédé revendiqué sera caractérisée

- par une épaisseur de la pellicule de matière conductrice (par exemple du cuivre et/ou de l'argent) supérieure à 100 nm, par exemple de plus de 150 nm, 200 nm, 250 nm, 300 nm, 400 nm, voire même de plus de 500 nm ; et/ou
- par une épaisseur de la pellicule de matière conductrice (par exemple du cuivre et/ou de l'argent) inférieure à 2 microns, par exemple de moins de 1,5 microns, voire même de moins de 1 micron ; et/ou
- par une épaisseur de la pellicule de produit d'impression (encre/vernis/toner) déposé (mesuré juste avant la mise en contact avec le film) supérieure à 3 microns, par exemple de plus de 10 microns ; et/ou
- par une épaisseur de la pellicule de produit d'impression (encre/vernis/toner) déposé (mesuré juste avant la mise en contact avec le film) inférieure à 200 microns, par exemple de moins de 100 microns.

On comprend de ce qui précède que la présente invention concerne également au moins un dispositif (ou un système) d'impression comprenant des moyens de mise en oeuvre d'au moins un des procédés décrits dans la présente demande. Grâce aux considérations conductrices fournies dans la présente demande, on comprend que de tels systèmes ou dispositifs comportent des moyens d'accomplir les fonctions décrites en référence au procédé et qu'il n'est pas nécessaire de détailler ces moyens.

La présente demande décrit diverses caractéristiques techniques et avantages en référence aux figures et/ou à divers modes de réalisation. L'homme de métier comprendra que les caractéristiques techniques d'un mode de réalisation donné peuvent en fait être combinées avec des caractéristiques d'un autre mode de réalisation à moins que l'inverse ne soit explicitement mentionné ou qu'il ne soit évident que ces caractéristiques sont incompatibles ou que la combinaison ne fournisse pas une solution à au moins un des problèmes techniques mentionnés dans la présente demande. De plus, les caractéristiques techniques décrites dans un mode de réalisation donné peuvent être isolées des autres caractéristiques de ce mode à moins que l'inverse ne soit explicitement mentionné.

Il doit être évident pour les personnes versées dans l'art que la présente invention permet des modes de réalisation sous de nombreuses autres formes spécifiques sans l'éloigner du domaine d'application de l'invention comme revendiqué. Par conséquent, les présents modes de réalisation doivent être considérés à titre d'illustration, mais peuvent être modifiés dans le domaine défini par la portée des revendications jointes, et l'invention ne doit pas être limitée aux détails donnés ci-dessus.

## Revendications

1. Dispositif d'identification par fréquence radio sans puce, le dit dispositif étant **caractérisé par** une composition multicouches comprenant

   - un substrat,
   - un motif imprimé numériquement sur le substrat et constitué d'un produit d'impression tel qu'une encre, un vernis et/ou un toner,
   - un motif identique superposé au motif imprimé et constitué d'un film conducteur comprenant une pellicule d'application en contact avec le produit d'impression et une pellicule conductrice, la pellicule d'application comprenant ou étant constituée d'une matière thermoplastique.

2. Dispositif d'identification par fréquence radio sans puce selon la revendication 1 **caractérisé en ce que** le motif imprimé est un diélectrique.

3. Dispositif d'identification par fréquence radio sans puce selon l'une quelconque des revendications précédentes **caractérisé en ce que** l'épaisseur du motif imprimé est supérieure à 3 micromètres et inférieure à 200 micromètres

4. Dispositif d'identification par fréquence radio sans puce selon la revendication 3 **caractérisé en ce que** l'épaisseur du motif imprimé est supérieure à 10 micromètres et inférieure à 100 micromètres.

5. Dispositif d'identification par fréquence radio sans puce selon l'une quelconque des revendications précédentes **caractérisé en ce que** l'épaisseur de pellicule conductrice est supérieure à 100 nm.

6. Dispositif d'identification par fréquence radio sans puce selon la revendication 5 **caractérisé en ce que** l'épaisseur de pellicule conductrice est supérieure à 150 nm, par exemple de plus de 200 nm, 250 nm, 300 nm, 400 nm, voire même de plus de 500 nm.

7. Dispositif d'identification par fréquence radio sans puce selon l'une quelconque des revendications précédentes **caractérisé en ce que** l'épaisseur de pellicule conductrice est inférieure à 2 micromètres, par exemple de moins de 1,5 micromètres, voire même de moins de 1 micromètre ou de moins de 0,75 micromètre.

8. Dispositif d'identification par fréquence radio sans puce selon l'une quelconque des revendications précédentes **caractérisé en ce que** l'épaisseur de pellicule conductrice est inférieure à 2,5 fois son épaisseur de peau à une fréquence donnée, la dite épaisseur de peau pouvant être calculée au moyen de la formule

$$\delta = \sqrt{\frac{2}{\omega\mu\sigma}} = \sqrt{\frac{2\rho}{\omega\mu}} = \frac{1}{\sqrt{\sigma\mu\pi f}}$$

dans laquelle $\delta$ est l'épaisseur de peau en mètre [m],

f est la fréquence du courant en hertz [Hz],
$\omega$ est la pulsation en radian par seconde [rad/s] ($\omega$=2.$\pi$.f)
$\sigma$ est la conductivité électrique en siemens par mètre [S/m]
$\rho$ est la résistivité en ohm-mètre [$\Omega$.m] ($\rho$=1/$\sigma$) , et
$\mu$ est la perméabilité magnétique en henry par mètre [H/m], cette perméabilité valant 4$\pi$10-7 pour le vide

9. Dispositif d'identification par fréquence radio sans puce selon l'une quelconque des revendications précédentes **caractérisé en ce que** le produit d'impression et la pellicule d'application comprennent une matière thermoplastique.

10. Dispositif d'identification par fréquence radio sans puce selon la revendication 9 **caractérisé en ce que** la matière thermoplastique de la pellicule d'application est **caractérisée par** une valeur de température de transition vitreuse « Tg » comprise entre 40°C et 80°C et **en ce que** la matière thermoplastique du produit d'impression est **caractérisée par** une valeur de Tg comprise entre 10 et 50°C.

11. Dispositif d'identification par fréquence radio sans puce selon l'une quelconque des revendications précédentes **caractérisé en ce qu'**il comprend une couche interstitielle comprenant de la matière du produit d'impression et de la matière de la pellicule d'application du film.

12. Procédé de fabrication de dispositifs d'identification par fréquence radio sans puce selon l'une quelconque des revendications précédentes **caractérisé en ce qu'**il comprend un procédé d'impression multi-couches comprenant

- une étape d'impression numérique d'un motif par impression d'un produit d'impression,
- suivie d'une étape de dépôt sélectif de film conducteur sur le motif préimprimé par contact entre le produit d'impression et la pellicule d'application du film conducteur comprenant une pellicule conductrice.

13. Procédé de fabrication de dispositifs d'identification par fréquence radio sans puce selon la revendication 12 **caractérisé en ce que** l'étape d'impression numérique du motif est effectuée par jet d'encre de vernis/encre ou par

impression électrophotographie de toner.

14. Utilisation du procédé de fabrication de dispositifs d'identification par fréquence radio sans puce selon la revendication 12 ou 13 **caractérisée en ce que** la signature RF du dispositif d'identification par fréquence radio est contrôlée par la sélection de la forme du motif conducteur et/ou par la sélection du type de produit d'impression et/ou par la sélection de l'épaisseur du produit d'impression.

**Patentansprüche**

1. Chiplose Radiofrequenz-Identifikationsvorrichtung, wobei die Vorrichtung durch eine Mehrschichtzusammensetzung gekennzeichnet ist, die enthält

   - ein Substrat,
   - ein Muster, das digital auf das Substrat gedruckt wird und aus einem Druckprodukt wie einer Tinte, einem Lack und/oder einem Toner besteht,
   - ein gleiches Muster, das das gedruckte Muster überlagert und aus einer leitfähigen Folie besteht, die einen Applikationsfilm in Kontakt mit dem Druckprodukt und einen leitfähigen Film enthält, wobei der Applikationsfilm ein thermoplastisches Material enthält oder daraus besteht.

2. Chiplose Radiofrequenz-Identifikationsvorrichtung nach Anspruch 1, **dadurch gekennzeichnet, dass** das gedruckte Muster ein Dielektrikum ist.

3. Chiplose Radiofrequenz-Identifikationsvorrichtung nach einem der vorhergehenden Ansprüche, **dadurch gekennzeichnet, dass** die Dicke des gedruckten Musters über 3 Mikrometer und unter 200 Mikrometer liegt.

4. Chiplose Radiofrequenz-Identifikationsvorrichtung nach Anspruch 3, **dadurch gekennzeichnet, dass** die Dicke des gedruckten Musters über 10 Mikrometer und unter 100 Mikrometer liegt.

5. Chiplose Radiofrequenz-Identifikationsvorrichtung nach einem der vorhergehenden Ansprüche, **dadurch gekennzeichnet, dass** die Dicke des leitfähigen Films über 100 nm liegt.

6. Chiplose Radiofrequenz-Identifikationsvorrichtung nach Anspruch 5, **dadurch gekennzeichnet, dass** die Dicke des leitfähigen Films über 150 nm liegt, zum Beispiel mehr als 200 nm, 250 nm, 300 nm, 400 nm, sogar mehr als 500 nm.

7. Chiplose Radiofrequenz-Identifikationsvorrichtung nach einem der vorhergehenden Ansprüche, **dadurch gekennzeichnet, dass** die Dicke des leitfähigen Films unter 2 Mikrometer liegt, zum Beispiel weniger als 1,5 Mikrometer, sogar weniger als 1 Mikrometer oder weniger als 0,75 Mikrometer.

8. Chiplose Radiofrequenz-Identifikationsvorrichtung nach einem der vorhergehenden Ansprüche, **dadurch gekennzeichnet, dass** die Dicke des leitfähigen Films unter dem 2,5-Fachen seiner Skindicke bei einer gegebenen Frequenz liegt, wobei die Skindicke mittels der folgenden Formel berechnet werden kann

$$\delta = \sqrt{\frac{2}{\omega\mu\sigma} = \sqrt{\frac{2\rho}{\omega\mu}} = \frac{1}{\sqrt{\sigma\mu\pi f}}}$$

   wobei

   δ die Skindicke in Meter [m] ist,
   f die Frequenz des Stroms in Hertz [Hz] ist,
   ω die Kreisfrequenz in Radiant pro Sekunde [rad/s] (ω=2.π.f) ist,
   σ die elektrische Leitfähigkeit in Siemens pro Meter [S/m] ist,
   ρ der spezifische Widerstand in Ohmmeter [Ω.m] (ρ=1/σ) ist, und
   μ die magnetische Permeabilität in Henry pro Meter [H/m] ist, wobei diese Permeabilität den Wert 4π10-7 für

das Vakuum hat.

**9.** Chiplose Radiofrequenz-Identifikationsvorrichtung nach einem der vorhergehenden Ansprüche, **dadurch gekennzeichnet, dass** das Druckprodukt und der Applikationsfilm ein thermoplastisches Material enthalten.

**10.** Chiplose Radiofrequenz-Identifikationsvorrichtung nach Anspruch 9, **dadurch gekennzeichnet, dass** das thermoplastische Material des Applikationsfilms durch einen Glasübergangstemperaturwert "Tg" gekennzeichnet ist, der zwischen 40°C und 80°C liegt, und dass das thermoplastische Material des Druckprodukts durch einen Wert von Tg zwischen 10 und 50°C gekennzeichnet ist.

**11.** Chiplose Radiofrequenz-Identifikationsvorrichtung nach einem der vorhergehenden Ansprüche, **dadurch gekennzeichnet, dass** sie eine Zwischenschicht enthält, die Material des Druckprodukts und Material des Applikationsfilms der Folie enthält.

**12.** Herstellungsverfahren von chiplosen Radiofrequenz-Identifikationsvorrichtungen nach einem der vorhergehenden Ansprüche, **dadurch gekennzeichnet, dass** es ein Mehrschicht-Druckverfahren enthält, das enthält

- einen Schritt des digitalen Drucks eines Musters durch Drucken eines Druckprodukts,
- gefolgt von einem Schritt des selektiven Aufbringens einer leitfähigen Folie auf das vorgedruckte Muster durch Kontakt zwischen dem Druckprodukt und dem Applikationsfilm der einen leitfähigen Film enthaltenden leitfähigen Folie.

**13.** Herstellungsverfahren von chiplosen Radiofrequenz-Identifikationsvorrichtungen nach Anspruch 12, **dadurch gekennzeichnet, dass** der Schritt des digitalen Druckens des Musters durch Tintenstrahl von Lack/Tinte oder durch Elektrophotographiedruck eines Toners ausgeführt wird.

**14.** Verwendung des Herstellungsverfahrens von chiplosen Radiofrequenz-Identifikationsvorrichtungen nach Anspruch 12 oder 13, **dadurch gekennzeichnet, dass** die RF-Signatur der Radiofrequenz-Identifikationsvorrichtung durch die Auswahl der Form des leitfähigen Musters und/oder durch die Auswahl des Druckprodukttyps und/oder durch die Auswahl der Dicke des Druckprodukts gesteuert wird.

## Claims

**1.** Chipless radiofrequency identification device, said device being **characterized by** a multilayer composition comprising

- a substrate,
- a pattern printed digitally on the substrate and consisting of a printing product such as an ink, a varnish and/or a toner,
- an identical pattern superimposed on the printed pattern and consisting of a conductive film comprising an application film layer in contact with the printing product and a conductive film layer, the application film layer comprising or consisting of a thermoplastic material.

**2.** Chipless radiofrequency identification device according to Claim 1, **characterized in that** the printed pattern is a dielectric.

**3.** Chipless radiofrequency identification device according to either one of the preceding claims, **characterized in that** the thickness of the printed pattern is greater than 3 micrometres and less than 200 micrometres.

**4.** Chipless radiofrequency identification device according to Claim 3, **characterized in that** the thickness of the printed pattern is greater than 10 micrometres and less than 100 micrometres.

**5.** Chipless radiofrequency identification device according to any one of the preceding claims, **characterized in that** the conductive film layer thickness is greater than 100 nm.

**6.** Chipless radiofrequency identification device according to Claim 5, **characterized in that** the conductive film layer thickness is greater than 150 nm, for example more than 200 nm, 250 nm, 300 nm, 400 nm, or even more than 500 nm.

**7.** Chipless radiofrequency identification device according to any one of the preceding claims, **characterized in that** the conductive film layer thickness is less than 2 micrometres, for example less than 1.5 micrometres, or even less than 1 micrometre or less than 0.75 micrometres.

**8.** Chipless radiofrequency identification device according to any one of the preceding claims, **characterized in that** the conductive film layer thickness is less than 2.5 times its skin thickness at a given frequency, said skin thickness being able to be calculated using the formula

$$\delta = \sqrt{\frac{2}{\omega\mu\sigma}} = \sqrt{\frac{2\rho}{\omega\mu}} = \frac{1}{\sqrt{\sigma\mu\pi f}}$$

where $\delta$ is the skin thickness in metres [m],

f is the frequency of the current in hertz [Hz],
w is the angular frequency in radians per second [rad/s] ($\omega$=2.$\pi$.f)
$\sigma$ is the electrical conductivity in siemens per metre [S/m]
$\rho$ is the resistivity in ohm-metres [$\Omega$.m] ($\rho$=1/$\sigma$), and
$\mu$ is the magnetic permeability in henries per metre [H/m], this permeability having the value 4$\pi$10-7 for a vacuum.

**9.** Chipless radiofrequency identification device according to any one of the preceding claims, **characterized in that** the printing product and the application film layer comprise a thermoplastic material.

**10.** Chipless radiofrequency identification device according to Claim 9, **characterized in that** the thermoplastic material of the application film layer is **characterized by** a glass transition temperature value "Tg" of between 40°C and 80°C and in that the thermoplastic material of the printing product is **characterized by** a Tg value of between 10 and 50°C.

**11.** Chipless radiofrequency identification device according to any one of the preceding claims, **characterized in that** it comprises an interstitial layer comprising material of the printing product and material of the application film layer of the film.

**12.** Method for manufacturing chipless radiofrequency identification devices according to any one of the preceding claims, **characterized in that** it comprises a multilayer printing method comprising

- a step of digitally printing a pattern by printing a printing product,
- followed by a step of selectively depositing conductive film on the preprinted pattern through contact between the printing product and the application film layer of the conductive film comprising a conductive film layer.

**13.** Method for manufacturing chipless radiofrequency identification devices according to Claim 12, **characterized in that** the step of digitally printing the pattern is performed through varnish/ink inkjet printing or through toner electrophotography printing.

**14.** Use of the method for manufacturing chipless radiofrequency identification devices according to Claim 12 or 13, **characterized in that** the RF signature of the radiofrequency identification device is controlled by selecting the shape of the conductive pattern and/or by selecting the type of printing product and/or by selecting the thickness of the printing product.

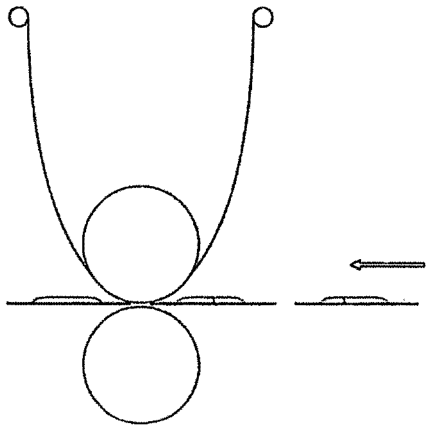

Figure 1

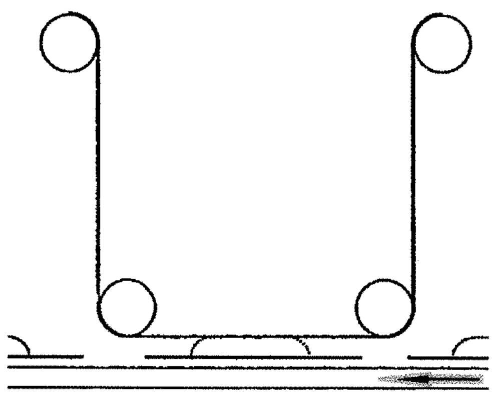

Figure 2

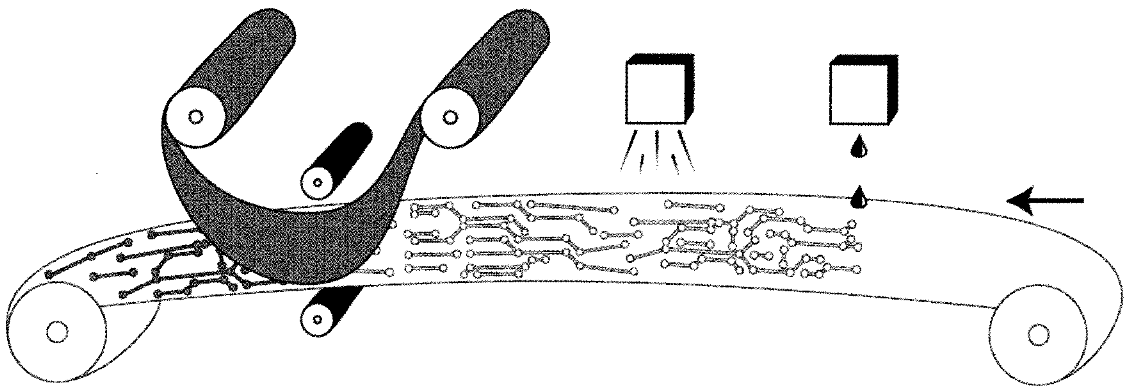

Figure 3

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description


- US 2009128290 A
- EP 2056656 A2
- CA 2089060 A1